(19) Europäisches Patentamt
European Patent Office
Office européen des brevets

(11) **EP 3 906 416 B1**

(12) **EUROPÄISCHE PATENTSCHRIFT**

(45) Veröffentlichungstag und Bekanntmachung des Hinweises auf die Patenterteilung:
**18.05.2022 Patentblatt 2022/20**

(21) Anmeldenummer: **20704483.5**

(22) Anmeldetag: **05.02.2020**

(51) Internationale Patentklassifikation (IPC):
**G01R 19/25** (2006.01)   **G01R 22/06** (2006.01)
**G01R 21/133** (2006.01)

(52) Gemeinsame Patentklassifikation (CPC):
**G01R 21/133; G01R 19/2513; G01R 22/063**

(86) Internationale Anmeldenummer:
**PCT/EP2020/052880**

(87) Internationale Veröffentlichungsnummer:
**WO 2020/164998 (20.08.2020 Gazette 2020/34)**

(54) **VERFAHREN ZUR VERTEILTEN ELEKTRISCHEN LEISTUNGSBESTIMMUNG**

METHOD FOR THE DISTRIBUTED DETERMINATION OF ELECTRICAL POWER

PROCÉDÉ DE DÉTERMINATION DE LA PUISSANCE ÉLECTRIQUE DISTRIBUÉE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.02.2019 DE 102019103270**

(43) Veröffentlichungstag der Anmeldung:
**10.11.2021 Patentblatt 2021/45**

(73) Patentinhaber: **Beckhoff Automation GmbH**
**33415 Verl (DE)**

(72) Erfinder:
• **ASSION, Fabian**
**33647 Bielefeld (DE)**
• **ENS, Jakob**
**33428 Harsewinkel (DE)**
• **LIENEN, Christian**
**33129 Delbrück (DE)**

(74) Vertreter: **Patentanwaltskanzlei WILHELM & BECK**
**Prinzenstraße 13**
**80639 München (DE)**

(56) Entgegenhaltungen:
**EP-A1- 2 241 898      EP-A1- 2 902 792**
**EP-A1- 2 903 297      WO-A1-2009/140777**
**CA-A1- 2 105 095      US-A- 4 581 705**
**US-A1- 2005 083 206   US-A1- 2008 195 794**
**US-A1- 2015 145 500   US-B1- 6 657 424**

**Beschreibung**

Die Erfindung betrifft ein Verfahren zur verteilten elektrischen Leistungsbestimmung für ein System mit zumindest einem Verbraucher. Die Erfindung betrifft ferner ein System zur verteilten Leistungsbestimmung. Die Erfindung betrifft zusätzlich ein Computerprogramm zum Ausführen eines Verfahrens zur verteilten Leistungsbestimmung und ein Speichermedium mit dem Computerprogramm.

Stand der Technik

Bei einer verteilten Leistungsbestimmung werden Strom und Spannung eines Systems mit wenigstens einem Verbraucher an verschiedenen Stellen des Systems aufgenommen. Gegenüber einer Leistungsbestimmung, bei der Spannung und Strom an derselben Stelle im System bestimmt werden, beispielsweise direkt beim Verbraucher, kann eine verteilte Leistungsbestimmung, speziell in Systemen mit mehreren Verbrauchern, den Vorteil ergeben, dass lediglich eine Spannungsmessung für mehrere Verbraucher durchgeführt werden muss. Der bei der Spannungsmessung bestimmte Wert für die Versorgungsspannung wird in Kombination mit den jeweils an den Stellen der Verbraucher bestimmten Verbraucherströmen zur Bestimmung der Leistung verwendet. Hierdurch können Hardwarekomponenten eingespart werden, da nicht für jeden Verbraucher eine individuelle Spannungsmesseinrichtung benötigt wird, sondern eine Spannungsmesseinrichtung für eine Mehrzahl von Verbrauchern ausreicht.

Aus dem Dokument WO 2013/009942 A1 ist ein Verfahren zur verteilten Leistungsbestimmung bekannt, bei dem eine Spannungsmessung an einem Punkt und eine Strommessung an einem anderen Punkt in einem System mit wenigstens einem Verbraucher durchgeführt wird.

Aus der Druckschrift WO 2009/140777 A1 ist eine Leistungsmessvorrichtung bekannt. Die Leistungsmessvorrichtung ist zur verteilten Leistungsbestimmung eingerichtet und umfasst wenigstens eine Spannungsmesseinrichtung und wenigstens eine Strommesseinrichtung, über die an verteilten Messpunkten Spannungs- und Strommessungen durchführbar sind.

Problematisch in den aus dem Stand der Technik bekannten Systemen zur verteilten Leistungsbestimmung ist jedoch die Übertragung der aufgenommenen Strom- und Spannungswerte zur Bestimmung der Leistung. Da Messwerte für Strom und Spannung an verschiedenen Stellen im System und von unterschiedlichen Systemkomponenten aufgenommen werden, muss wenigstens ein Datensatz von der einen Systemkomponente an eine weitere Systemkomponente übermittelt werden, um unter Berücksichtigung der aufgenommenen Spannung und des aufgenommenen Stroms die entsprechende Leistung bestimmen zu können.

Bei Wechselspannung wird im Stand der Technik die Leistung auf Basis von Effektivwerten für Strom und Spannung bestimmt. Dies ist unter anderem darauf gegründet, dass zur exakten Bestimmung der Leistung auf Momentanwerte für Strom und Spannung zurückgegriffen werden müsste. Dies würde jedoch das Übermitteln großer Datenmengen bedeuten, was bei derzeitigen Systemen zu Problemen führt.

Die Bestimmung der Leistung basierend auf Effektivwerten für Strom und Spannung ist jedoch ebenfalls nicht zufriedenstellend. Effektivwerte für Strom und Spannung stellen eine starke Vereinfachung gegenüber den tatsächlichen Momentanwerten dar und ein Großteil der in den Momentanwerten enthaltene Information gehen bei der Vereinfachung zu Effektivwerten verloren. Speziell bei Systemen mit vergleichsweise hohen Anteilen an Oberfrequenzen in Strom und Spannung führen diese Vereinfachungen zu Messungenauigkeiten in der Leistungsbestimmung.

Offenbarung der Erfindung

Die der Erfindung zugrundeliegende Aufgabe kann darin gesehen werden, ein effizientes Verfahren zur verteilten elektrischen Leistungsbestimmung eines Systems mit zumindest einem Verbraucher, ein System zur verteilten elektrischen Leistungsbestimmung und ein Speichermedium mit einem Computerprogramm zum Ausführen eines Verfahrens zur verteilten elektrischen Leistungsbestimmung bereitzustellen.

Die Aufgabe wird mittels der Gegenstände der unabhängigen Ansprüche gelöst. Vorteilhafte Ausgestaltungen der Erfindung sind Gegenstand der jeweils abhängigen Ansprüche.

Nach einem Aspekt der Erfindung wird ein Verfahren laut dem Anspruch 1 zur verteilten elektrischen

Leistungsbestimmung zumindest eines Verbrauchers bereitgestellt.

Hierdurch wird erreicht, dass ein effizientes Verfahren zur verteilten Leistungsbestimmung in einem System mit zumindest einem Verbraucher bereitgestellt werden kann.

Durch die verteilte Leistungsbestimmung, worunter im Folgenden eine Leistungsbestimmung verstanden wird, bei der Spannung und Strom an unterschiedlichen Stellen im System gemessen werden, kann eine Reduzierung der benötigten Hardware bewirkt werden.

Besonders in Systemen mit einer Mehrzahl von Verbrauchern kann mit nur einer Spanungsmesseinrichtung und einer Mehrzahl von den einzelnen Verbrauchern zugeordneten Strommesseinrichtungen eine Leistungsbestimmung für jeden der Verbraucher erreicht werden.

Eine individuelle Spannungsmessung für jeden Verbraucher kann vermieden werden.

Diese sind speziell für Systeme unvorteilhaft, in denen die Versorgungsspannung für die verschiedenen Verbraucher lediglich geringfügig variiert. Lokale Spannungsmessungen für jeden Verbraucher bringen in solchen Systemen gegenüber einer einzigen globalen Spannungsmessung der Versorgungsspannung für das gesamte System keine zusätzliche Information und sind folglich redundant.

Eine verteilte Leistungsbestimmung setzt jedoch voraus, dass zur Bestimmung wenigstens eines Leistungswerts Spannungsmesswerte der Versorgungsspannung und/oder Strommesswerte des Verbraucherstroms von der Spannungsmesseinrichtung und/oder von der Strommesseinrichtung zu einer entsprechenden Systemkomponente übermittelt werden, von der die jeweiligen Messwerte der Spannung und des Stroms zur Bestimmung einer entsprechenden Leistung herangezogen werden, wobei die Messwerte Spannungsmesswerte und/oder Strommesswerte umfassen.

Diesbezüglich wird der Vorteil erreicht, dass im vorliegenden Verfahren zur Übertragung der aus den aufgenommenen Spannungs- und Strommesswerten erhaltenen Information bezüglich der Versorgungsspannung und/oder des Verbraucherstroms ein vergleichsweise geringes Datenvolumen übermittelt werden muss. Hierdurch ist eine schnellere Übertragung der Daten und damit verbunden eine schnellere Leistungsbestimmung für die einzelnen Verbraucher des Systems ermöglicht.

Aufgrund der höheren Informationsdichte der Kenngrößen, wobei die Kenngrößen durch Spannungs- und/oder Strommesswerte gebildet sein können, gegenüber nichtanalysierten Spannungs- und Strommesswerten kann darüber hinaus mit der Übermittlung von Spannungskenngrößen und/oder Stromkenngrößen ein höherer Informationsgehalt pro übertragenem Datenvolumen erzielt werden. Bei einem vorbestimmten maximal übertragbaren Datenvolumen können die übertragenen Kenngrößen damit einen höheren Informationsgehalt übertragen, als dies bei Spannungbeziehungsweise Strommesswerten des gleichen Datenvolumens möglich wäre. Beispielsweise können Kenngrößen übermittelt werden, die einen Satz von Spannungs- und/oder Strommesswerten entsprechen, dessen Datenvolumen das maximal übertragbare Datenvolumen übersteigen würde. Alternativ können auch Kenngrößen zu mehreren Sätzen von Spannungs- und/oder Strommesswerten übermittelt werden, während aufgrund des hohen Datenvolumens der einzelnen Datensätze der Spannungs- und/oder Strommesswerte nicht alle Datensätze gleichzeitig übermittelbar wären.

Die aufgenommenen Spannungsmesswerte der Versorgungsspannung und/oder die Strommesswerte des Versorgungsstroms werden vor dem Übermitteln an die entsprechende Systemkomponente zur Leistungsbestimmung eines Analyseprozesses unterzogen. In der Datenanalyse werden Spannungskenngrößen des Spannungsverlaufs der Versorgungsspannung und/oder Stromkenngrößen des Stromverlaufs des Verbraucherstroms ermittelt.

Die ermittelten Spannungsgrößen und/oder Stromkenngrößen werden darauffolgend an die Systemkomponente übermittelt, die unter Berücksichtigung der Spannungsgrößen und/oder Stromkenngrößen die Leistung des jeweiligen Verbrauchers bestimmt. Anstatt der aufgenommenen Spannungs- und/oder Strommesswerte werden somit die Spannungskenngrößen und/oder Stromkenngrößen übermittelt, wodurch eine substantielle Reduktion der zu übermittelnden Datenmengen erreicht wird.

Die Spannungsmesswerte oder die Strommesswerte werden analysiert und die Spannungskenngrößen oder die Stromkenngrößen ermittelt in Abhängigkeit davon, welche der Spannungsmesswerte beziehungsweise der Spannungskenngrößen oder der Strommesswerte beziehungsweise der Stromkenngrößen übermittelt werden sollen. Sollen sowohl Spannungs- als auch Strommesswerte zur Bestimmung des wenigstens einen Leistungswerts zu der entsprechenden Systemkomponente übermittelt werden, werden sowohl die Spannungsmesswerte analysiert und die Spannungskenngrößen ermittelt als auch die Strommesswerte analysiert und die Stromkenngrößen ermittelt.

Es werden ausschließlich Kenngrößen von der Spannungsmesseinrichtung oder der zumindest einen Strommesseinrichtung an die jeweilige Systemkomponente, die die Leistungsbestimmung durchführt, übermittelt. Eine Übermittlung von Spannungs- oder Strommesswerten findet nicht statt.

Die Bestimmung der Leistung erfolgt unter Berücksichtigung der Spannungskenngrößen und/oder Stromkenngrößen. Beispielsweise können die Kenngrößen derart ausgebildet sein, dass eine Multiplikation der Spannungskenngrößen und Stromkenngrößen zu einem entsprechenden Leistungswert führt.

Eine Rücktransformation der Spannungskenngrößen und Stromkenngrößen in die entsprechenden Spannungs- und Strommesswerte ist ebenfalls möglich. Die Leistungsbestimmung erfolgt in diesem Fall unter Berücksichtigung der Spannungs- und Strommesswerte. Die entsprechende Rücktransformation kann durch die zur Leistungsbestimmung dienende Systemkomponente durchgeführt werden, nachdem die Spannungskenngrößen und/oder Stromkenngrößen von der Spannungsmesseinrichtung und/oder der zumindest einen Strommesseinrichtung an die entsprechende Leistungskomponente übermittelt worden ist.

Das Datenvolumen der zu übermittelnden Spannungskenngrößen oder Stromkenngrößen ist erheblich herabgesetzt zu einem Datenvolumen der Spannungsmesswerte oder der Strommesswerte. Die Kenngrößen sind hierbei so gewählt, dass der Informationsgehalt der Spannungskenngrößen oder der Stromkenngrößen dem Informationsgehalt der Spannungsmesswerte oder der Strommesswerte entspricht. Mindestens durch eine Rücktransformation der Spannungskenngrößen und/oder Stromkenngrößen in die Spannungs- und/oder Strommesswerte kann der Informationsgehalt wiederhergestellt werden.

Ein Verlauf, insbesondere der Versorgungsspannung, welcher auch als Spannungsverlauf bezeichnet wird, oder des Verbraucherstroms, welcher auch als Stromverlauf bezeichnet wird, ist im Folgenden eine zeitliche Entwicklung der Versorgungsspannung oder des Verbraucherstroms und ist durch die jeweiligen Spannungsmesswerte oder Strommesswerte bestimmt. Der Spannungsverlauf oder Stromverlauf kann durch eine passende mathematische Funktion beziehungsweise durch einen entsprechenden Graph der Funktion wiedergegeben werden.

Eine Analysefunktion ist im Folgenden eine mathematische Funktion, die zur Analyse der Spannungsmesswerte und der Strommesswerte verwendet wird, und die geeignet ist, die Spannungsmesswerte und die Strommesswerte wiederzugeben und die entsprechenden Spannungsverläufe der Versorgungsspannung und Stromverläufe des Verbraucherstroms zu beschreiben.

Eine Analysefunktion im vorliegenden Sinne kann auch eine jeweilige Umkehrfunktion umfassen, die den Analysevorgang auf den Ausgang zurückführt. Voraussetzung hierbei ist jedoch, dass die Umkehrfunktion eine eindeutige Zuordnung der Kenngröße und der zu analysierenden Messwerte ermöglicht, sodass die Umkehrfunktion unter Berücksichtigung der Kenngrößen eindeutig die Messwerte wiedergibt.

Kenngrößen sind im Folgende Größen beziehungsweise Parameter der Analysefunktion, die einen Informationsgehalt bezüglich der Verläufe der jeweiligen Messwerte transportieren können. Beispielsweise können Kenngrößen, Parameter einer Anpassungsfunktion sein, mittels der Messwerte analysiert werden, indem über eine Variation der Kenngrößen die Anpassungsfunktion an die zu analysierenden Daten angepasst wird, wobei die analysierenden Daten durch Spannungs- und/oder Strommesswerte gebildet sein können.

Die Kenngrößen können beispielsweise auch weitere Größen sein, die mittels der Datenanalyse aus den Messwerten extrahiert werden. Die Analysefunktion kann in einem derartigen Fall im weitesten Sinne eine Handlungsvorschrift zur Durchführung der Analyse und zur Extraktion der Kenngrößen sein.

Die Kenngrößen transportieren damit einen eindeutigen Informationsgehalt bezüglich der aufgenommenen Messwerte. Unter Berücksichtigung der jeweiligen Analysefunktion ermöglichen die Kenngrößen eine eindeutige Wiedergabe der Messwerte und eine Beschreibung des Verlaufs.

Die Kenngrößen und die Analysefunktion stehen dabei in einem Verhältnis, dass die Kenngrößen Parameter der Analysefunktion sind. Nehmen die jeweiligen Kenngrößen durch die vorangegangene Analyse der Messwerte die passenden Werte an, lassen sich die jeweiligen Messwerte durch die Analysefunktion unter Berücksichtigung der Kenngrößen darstellen und wiedergeben.

Nach einer Ausführungsform wird die Analyse der Spannungsmesswerte der Versorgungsspannung in dem Analyseschritt von der Spannungsmesseinrichtung durchgeführt,
wobei die Analyse der Strommesswerte des Verbraucherstroms in dem Analyseschritt von der zumindest einen Strommesseinrichtung durchgeführt wird.

Hierdurch wird der technische Vorteil erreicht, dass zur Ermittlung der Leistung keine Messwerte übertragen werden müssen.

Durch die Analyse der Spannungsmesswerte der Versorgungsspannung in der Spannungsmesseinrichtung und/oder der Strommesswerte des Verbraucherstroms in der zumindest einen Strommesseinrichtung und durch das damit verbundene Erstellen der entsprechenden Spannungskenngrößen und/oder Stromkenngrößen kann vermieden werden, dass ganze Sätze von aufgenommenen Messwerten der Versorgungsspannung und/oder des Verbraucherstroms zu Bestimmung eines entsprechenden Leistungswerts an die jeweilige Systemkomponente übermittelt werden müssen.

Statt der aufgenommenen Messwerte werden ausschließlich die ermittelten Kenngrößen übermittelt. Durch die Wahl der Kenngrößen derart, dass unter Berücksichtigung der jeweiligen Analysefunktion die entsprechenden Messwerte wiedergegeben werden können, transportieren die Spannungskenngrößen und/oder Stromkenngrößen einen Informationsgehalt, welcher dem Informationsgehalt der Messwerte entsprechen kann.

Nach einer Ausführungsform umfasst der Analyseschritt der Spannungsmesswerte und/oder der Strommesswerte die Verfahrensschritte: Durchführen einer Spektralanalyse, insbesondere einer diskreten Fourier-Analyse, der Spannungsmesswerte und/oder der Strommesswerte in einem Spektralanalyseschritt, Erstellen eines Spannungsfrequenzspektrums der Versorgungsspannung auf Basis der Spektralanalyse der Spannungsmesswerte und/oder eines Stromfrequenzspektrums des Verbraucherstroms auf Basis der Spektralanalyse der Strommesswerte in einem Spektrumerstellungsschritt, Reduzieren des Spannungsfrequenzspektrums der Versorgungsspannung und/oder des Stromfrequenzspektrums des Verbraucherstroms auf Frequenzen einer Spannungsgrundfrequenz und von ersten n Spannungsoberfrequenzen der Versorgungsspannung und/oder auf Frequenzen einer Stromgrundfrequenz und von ersten n Stromoberfrequenzen des Verbraucherstroms in einem Reduktionsschritt, und Identifizieren der Spannungsspektralwerte für Frequenzen der Spannungsgrundfrequenz und der ersten n Spannungsoberfrequenzen der Versorgungsspannung als Spannungskenngrößen und/oder der Stromspektralwerte für Frequenzen der Stromgrundfrequenz und der ersten n Stromoberfrequenzen des Verbraucherstroms als Stromkenngrößen in einem Spektralwertidentifikationsschritt.

Hierdurch wird der technische Vorteil erreicht, dass durch die Spektralanalyse die Versorgungsspannung und/oder der Verbraucherstrom anteilsmäßig in jeweils eine Grundfrequenz, wobei die Grundfrequenz durch eine Spannungsgrundfrequenz und/oder eine Stromgrundfrequenz gebildet sein kann, und bis zu n Oberfrequenzen, wobei die Oberfrequenzen durch eine Spannungsoberfrequenz und/oder eine Stromoberfrequenz gebildet sein können, aufgeteilt werden kann.

Die über die diskrete Fourier-Analyse bestimmten Spektralwerte der Versorgungsspannung und/oder des Verbraucherstroms für die jeweilige Grundfrequenz beziehungsweise die Grundfrequenz und die ersten n Oberfrequenzen stellen die Spannungskenngrößen und Stromkenngrößen dar. Die entsprechende Fourier-Reihe, in der die Spektralwerte als Reihenparameter fungieren, dient als Analysefunktion, mittels der die Spannungs- und Strommesswerte wiedergegeben werden können.

Neben dem Vorteil einer Reduzierung des Datenvolumens der zu übermittelnden Datenpakete, indem anstatt einer Übermittlung der Messwerte lediglich entsprechende Kenngrößen, die Spektralwerte für die Grund- und Oberfrequenzen, übermittelt werden, wird der Vorteil erreicht, dass durch die Aufspaltung der Versorgungsspannung und/oder des Verbraucherstroms in Grund- und Oberfrequenzen eine detaillierte Bestimmung verschiedener Spannungswerte und/oder Stromwerte ermöglicht ist.

Beispielsweise können neben der Scheinleistung auch die Wirkleistung, die Blindleistung oder die Verzerrungsblindleistung bestimmt werden. Hierdurch ist es ermöglicht, den Einfluss der Oberfrequenzen zu betrachten. Somit können Fehler, die beispielsweise bei einer Bestimmung der Leistung auf Basis von Effektivwerten für Strom und Spannung, bei der ein Einfluss von Oberfrequenzen vernachlässigt wird, vermieden werden.

Unter einer Grundfrequenz eines periodischen Signals wird die maßgebliche Frequenz des Signals verstanden, über die die längste Periode des periodischen Signals bestimmt ist. Die Grundfrequenz ist die niedrigste Frequenz der periodischen Anteile des periodischen Signals. Oberfrequenzen weisen hingegen Frequenzenzahlen auf, die ein ganzzahliges Vielfaches der Grundfrequenz sind. Im Folgenden können Grundwellen, Grundschwingungen und Grundfrequenzen synonym verwendet werden. Zu verstehen ist ein periodischer Anteil eines periodischen Spannungs- oder Stromsignals mit der Frequenz der Grundfrequenz des Signals. Analoges gilt für die Begriffe Oberwelle, Oberschwingung und Oberfrequenz, die ebenfalls synonym verwendet werden können.

Nach einer Ausführungsform umfasst der Spektralanalyseschritt ferner, Ermitteln von wenigstens einem Spannungsgleichanteil der Versorgungsspannung und/oder von wenigstens einem Stromgleichanteil des Verbraucherstroms, wobei im Spektralidentifikationsschritt der wenigstens eine Spannungsgleichanteil als eine Spannungskenngröße und/oder der wenigstens eine Stromgleichanteil als eine Stromkenngröße identifiziert wird.

Hierdurch wird der Vorteil einer präziseren Spektralanalyse erreicht.

Nach einer Ausführungsform umfasst der Analyseschritt der Spannungsmesswerte und/oder der Strommesswerte die Verfahrensschritte: Durchführen eines Anpassungsprozesses einer Anpassungsfunktion an die Spannungsmesswerte und/oder die Strommesswerte in einem Anpassungsschritt, Ermitteln von Spannungsparametern der Anpassungsfunktion, wobei die Anpassungsfunktion mit den Spannungsparametern den Spannungsverlauf der Versorgungsspannung beschreibt, und/oder von Stromparametern der Anpassungsfunktion in einem Parameterermittlungsschritt, wobei die Anpassungsfunktion mit den Stromparametern den Stromverlauf des Verbraucherstroms beschreibt, und Identifizieren der Spannungsparameter der Anpassungsfunktion als Spannungskenngrößen und/oder der Stromparameter der Anpassungsfunktion als Stromkenngrößen in einem Parameteridentifikationsschritt.

Hierdurch wird der technische Vorteil erreicht, dass eine einfache Analyse der Spannungsmesswerte der Versorgungsspannung und/oder der Strommesswerte des Verbraucherstroms bereitgestellt werden kann.

Eine Anpassungsfunktion ist im Folgenden eine mathematische Funktion, die geeignet ist, in einem Anpassungsprozess mittels Variation entsprechender Parameter an die jeweiligen zu analysierenden Messwerte angepasst zu werden, sodass die angepasste Funktion die entsprechenden Messwerte wiedergibt und einen Verlauf der Messwerte beschreibt.

Mit den entsprechend variierten Parametern ermöglicht die Anpassungsfunktion eine eindeutige Wiedergabe der Messwerte und Beschreibung des Verlaufs der Messwerte. Die Anpassungsfunktion kann den Anforderungen entsprechend gewählt werden. Beispielsweise kann eine möglichst komplexe Anpassungsfunktion mit einer hohen Anzahl zu variierender Parameter gewählt werden, um so eine möglichst exakte Anpassung der Anpassungsfunktion an die Messwerte und ein möglichst präzises Ergebnis für die zu bestimmende Leistung zu erreichen.

Beispielsweise kann aber auch eine vergleichsweise einfach gestaltete Anpassungsfunktion mit einer vergleichsweise geringeren Anzahl von Parametern gewählt werden, um eine möglichst schnelle Analyse zu erreichen, die wenig Prozessorleistung benötigt. Die Anpassungsfunktion kann der Analysefunktion entsprechen.

Nach einer Ausführungsform umfasst das Verfahren ferner den Verfahrensschritt: Synchronisieren der Spannungsmesseinrichtung und der zumindest einen Strommesseinrichtung auf eine Referenzzeit in einem Synchronisationsschritt, wobei die Spannungsmesseinrichtung und die zumindest eine Strommesseinrichtung jeweils eine lokale Zeit bestimmen, und wobei die lokale Zeit der Spannungsmesseinrichtung und die lokale Zeit der zumindest einen Strommesseinrichtung in Bezug auf die Referenzzeit angepasst werden.

Hierdurch kann erreicht werden, dass die Messungen, wobei die Messungen durch Spannungsmesswerte und Strommesswerte gebildet sein können, der Versorgungsspannung und des Verbraucherstroms aufeinander abstimmbar sind. So kann gewährleistet werden, dass bei der verteilten Leistungsbestimmung, bei der Strom und Spannung an unterschiedlichen Stellen im System gemessen werden, die jeweiligen Messungen zu aufeinander abgestimmten Zeiten durchgeführt werden, und so ein aussagekräftiges Ergebnis für die Leistungsbestimmung erzielt werden kann.

Nach einer Ausführungsform umfasst die Synchronisation der Spannungsmesseinrichtung und der zumindest einen Strommesseinrichtung in dem Synchronisationsschritt das Ermitteln einer Phasenverschiebung zwischen dem Spannungserlauf der Versorgungsspannung und dem Stromverlauf des Verbraucherstroms in einem Phasenverschiebungsermittlungsschritt.

Hierdurch wird der technische Vorteil erreicht, dass mittels der ermittelten Phasenverschiebung eine Synchronisation der jeweiligen Messungen von Versorgungsspannung und Verbraucherstrom erreicht wird.

Nach einer Ausführungsform ist der zumindest eine Leistungswert eine Wirkleistung, eine Blindleistung, eine Verzerrungsblindleistung oder eine Gesamtscheinleistung.

Hierdurch wird der technische Vorteil erreicht, dass eine präzise Bestimmung der Leistung ermöglicht ist. Somit kann in jeder Messung ein hoher Informationsgehalt erreicht werden, indem verschiedene Faktoren der Leistung zugänglich sind.

Nach einem zweiten Aspekt der Erfindung wird ein System laut dem Anspruch 7 zur verteilten elektrischen Leistungsbestimmung bereitgestellt.

Hierdurch wird der technische Vorteil erreicht, dass ein effizientes System zur verteilten Leistungsbestimmung bereitgestellt werden kann.

Die Spannungsmesseinrichtung und die zumindest eine Strommesseinrichtung nehmen an verschiedenen Orten im System Spannungsmesswerte für die Versorgungsspannung und Strommesswerte für den Verbraucherstrom auf. Damit können speziell bei Systemen mit einer Mehrzahl von Verbrauchern zusätzliche Spannungsmesseinrichtungen mit den damit verbundenen Verkabelungen eingespart werden, die bei einer Spannungs- und Strommessung an einem Ort für jeden der Verbraucher benötigt werden.

In den jeweiligen Spannungs- und Strommesseinrichtungen können die aufgenommenen Messwerte in Bezug auf bestimmte Kenngrößen analysiert werden. Die jeweiligen Spannungskenngrößen und Stromkenngrößen können in ersten Datenpaketen und zweiten Datenpaketen geordnet werden, wobei Spannungskenngrößen in ersten Datenpaketen und Stromkenngrößen in zweiten Datenpaketen zusammengeführt sind. Durch das Erstellen der Spannungskenngrößen und Stromkenngrößen und das Einordnen der Spannungskenngrößen und Stromkenngrößen in erste Datenpakete und zweite Datenpakete kann vermieden werden, dass zur Leistungsbestimmung ganze Sätze von Spannungsmesswerten und Strommesswerten übermittelt werden müssen.

Die ersten Datenpakete und/oder zweiten Datenpakete können von der Spannungsmesseinrichtung und/oder von der zumindest einen Strommesseinrichtung an eine Prozessoreinheit übermittelt werden, in der eine Leistungsbestimmung unter Berücksichtigung der Spannungskenngrößen und/oder Stromkenngrößen durchführbar ist.

Die Prozessoreinheit ist ausgebildet, unter Berücksichtigung der Spannungskenngrößen und/oder Stromkenngrößen eine Bestimmung der jeweiligen Leistung durchzuführen.

Hierzu kann die Prozessoreinheit die Spannungskenngrößen und die Stromkenngrößen zur Leistungsbestimmung berücksichtigen.

Die Prozessoreinheit kann ebenfalls eine Analyse mit der Analysefunktion von Spannungsmesswerten oder Strommesswerten durchführen, die zuvor nicht analysiert und nicht übermittelt wurden.

Die Prozessoreinheit kann ebenfalls eine Rücktransformation von Spannungskenngrößen oder Stromkenngrößen in die entsprechenden Spannungsmesswerte oder Strommesswerte durchführen. Hierzu verwendet die Prozessoreinheit die eindeutige Umkehrfunktion der Analysefunktion. In diesem Fall kann die Prozessoreinheit zur Bestimmung der Leistung die Spannungsmesswerte und die Strommesswerte berücksichtigen.

Nach einer Ausführungsform sind die Spannungsmesseinrichtung, die zumindest eine Strommesseinrichtung und die Prozessoreinheit ausgebildet, eine Spektralanalyse, insbesondere eine diskrete Fourier-Analyse, der Spannungsmesswerte und/oder Strommesswerte der durchzuführen, ein Spannungsfrequenzspektrum der Versorgungsspannung auf Basis der Spektralanalyse der Spannungsmesswerte und/oder ein Stromfrequenzspektrum des Verbraucherstroms auf Basis der Spektralanalyse der Strommesswerte zu erstellen, das Spannungsfrequenzspektrum der Versorgungsspannung und/oder das Stromfrequenzspektrum des Verbraucherstroms auf Spannungsspektralwerte einer Spannungsgrundfrequenz und von ersten n Spannungsoberfrequenzen der Versorgungsspannung und/oder auf Stromspektralwerte einer Stromgrundfrequenz und von ersten n Stromoberfrequenzen des Verbraucherstroms zu reduzieren, und die Spannungsspektralwerte für Frequenzen der Spannungsgrundfrequenz und der ersten n Spannungsoberfrequenzen der Versorgungsspannung als Spannungskenngrößen und/oder die Stromspektralwerte für Frequenzen der Stromgrundfrequenz und der ersten n Stromoberfrequenzen des Verbraucherstroms als Stromkenngrößen zu identifizieren.

Hierdurch wird der technische Vorteil erreicht, dass mit dem System eine Spektralanalyse der Versorgungsspannung und/oder des Verbraucherstroms vorgenommen werden kann, und auf diese Weise die Versorgungsspannung und/oder der Verbraucherstrom anteilsmäßig in jeweils eine Grundfrequenz und bis zu n Oberfrequenzen aufgeteilt werden kann.

Durch die Spektralanalyse kann neben dem Vorteil einer Reduzierung des Datenvolumens der zu übermittelnden Datenpakete durch die Übermittlung der Spektralwerte für die Grund- und Oberfrequenzen statt der Spannungsmesswerte und/oder Strommesswerte durch die Aufspaltung der Versorgungsspannung und/oder des Verbraucherstroms in Grund- und Oberfrequenzen eine detaillierte Bestimmung verschiedener Spannungswerte und Stromwerte erreicht werden.

Beispielsweise können neben der Scheinleistung auch die Wirkleistung, die Blindleistung oder die Verzerrungsblindleistung bestimmt werden. Hierdurch ist es ermöglicht, den Einfluss der Oberfrequenzen der Versorgungsspannung und des Verbraucherstroms zu betrachten. Somit können Fehler, die beispielsweise bei einer Bestimmung der Leistung auf Basis von Effektivwerten für Strom und Spannung, bei der ein Einfluss von Oberfrequenzen vernachlässigt wird, vermieden werden.

Nach einer Ausführungsform sind die Spannungsmesseinrichtung, die zumindest eine Strommesseinrichtung und die Prozessoreinheit ausgebildet, einen Anpassungsprozess einer Anpassungsfunktion an die Spannungsmesswerte und/oder die Strommesswerte durchzuführen, Spannungsparameter und/oder Stromparameter der Anpassungsfunktion zu bestimmen, und die Spannungsparameter der Anpassungsfunktion als Spannungskenngrößen und/oder die Stromparameter der Anpassungsfunktion als Stromkenngrößen zu identifizieren.

Hierdurch wird der technische Vorteil erreicht, dass eine einfache Analyse der Spannungsmesswerte der Versorgungsspannung und/oder der Strommesswerte des Verbraucherstroms bereitgestellt werden kann.

Nach einer Ausführungsform umfasst das System ferner zumindest eine Kommunikationsverbindung zwischen der Spannungsmesseinrichtung und der zumindest einen Prozessoreinheit und/oder der zumindest einen Strommesseinrichtung und der zumindest einen Prozessoreinheit zum Übermitteln des ersten Datenpakets von der Spannungsmesseinrichtung an die zumindest eine Prozessoreinheit und/oder des zweiten Datenpakets von der zumindest einen Strommesseinrichtung an die zumindest eine Prozessoreinheit.

Hierdurch wird der technische Vorteil erreicht, dass die ersten und/oder zweiten Datenpakete zwischen der Spannungsmesseinrichtung, der zumindest einen Strommesseinrichtung und/oder der einer externen Prozesseinheit übermittelt werden können.

Nach einer Ausführungsform ist die zumindest eine Prozessoreinheit in der Spannungsmesseinrichtung und/oder in der zumindest einen Strommesseinrichtung ausgebildet oder eine externe Prozessoreinheit.

Hierdurch wird erreicht, dass die Leistungsbestimmung sowohl in der Spannungsmesseinrichtung, in der zumindest einen Strommesseinrichtung oder in einer externen Prozessoreinheit durchgeführt werden kann.

Hierdurch wird der technische Vorteil einer hohen Flexibilität erreicht. Die Bestimmung der Leistung kann in der zumindest einen Strommesseinrichtung durchgeführt werden, hierzu müssen die Spannungskenngrößen von der Spannungsmesseinrichtung zur Strommesseinrichtung übertragen werden.

Die Leistungsbestimmung kann auch in der Spannungsmesseinrichtung vorgenommen werden. Dies wiederum setzt voraus, dass die Stromkenngrößen von der zumindest einen Strommesseinrichtung zur Spannungsmesseinrichtung übertragen werden.

Bei der Bestimmung der Leistung in der Spannungsmesseinrichtung oder der zumindest einen Strommesseinrichtung müssen entweder die Spannungskenngrößen und die Stromkenngrößen oder die Spannungsmesswerte und die Strommesswerte vorliegen.

Für den Fall, dass nur ein Datensatz übermittelt werden musste, weil die Prozessoreinheit in der Spannungsmesseinrichtung oder der Strommesseinrichtung ausgebildet ist, und somit nur die Spannungsmesswerte oder die Strommesswerte in die entsprechenden Spannungskenngrößen oder die Stromkenngrößen umgewandelt wurden, müssen zur Bestimmung der Leistung durch die Prozessoreinheit aus den jeweils bis dato nichtanalysierten Spannungsmesswerten oder Strommesswerten entsprechende Spannungskenngrößen oder Stromkenngrößen bestimmt werden.

Alternativ ist auch eine Rücktransformation der Spannungskenngrößen oder Stromkenngrößen durch die Prozessoreinheit möglich, sodass die Leistungsbestimmung auf Basis der Spannungsmesswerte und der Strommesswerte durchgeführt werden kann.

Die Prozessoreinheit ist ausgebildet die Spannungskenngrößen und/oder Stromkenngrößen aus den Spannungs- und/oder Strommesswerten zu erstellen. Die Prozessoreinheit ist ebenfalls ausgebildet, eine Rücktransformation der Spannungskenngrößen und/oder Stromkenngrößen in die entsprechenden Spannungsmesswerte und/oder Strommesswerte durchzuführen.

Alternativ kann die Leistungsbestimmung auch in einer externen Prozessoreinheit durchgeführt werden. Hierzu müssen sowohl die Spannungskenngrößen von der Spannungsmesseinrichtung als auch die Stromkenngrößen von der zumindest einen Strommesseinrichtung an die externe Prozessoreinheit übermittelt werden.

Nach einer Ausführungsform ist die Kommunikationsverbindung des Systems ein Bussystem, bei dem Informationen der Spannungsmesseinrichtung und der zumindest einen Strommesseinrichtung von der zumindest einen Strommesseinrichtung gelesen werden kann, oder ein zentralisierten Master-Slave System, bei dem die Information der Spannungsmesseinrichtung über einen zentralen Master an die zumindest eine Strommesseinrichtung gesendet wird.

Hierdurch wird der technische Vorteil einer verlässlichen und schnellen Datenübertragung erreicht.

Nach einer weiteren Ausführungsform sind die Spannungsmesseinrichtung und die zumindest eine Strommesseinrichtung zueinander synchronisierbar, wobei die Spannungsmesseinrichtung und die zumindest eine Strommesseinrichtung hierzu jeweils eine lokale individuelle Zeitbestimmung aufweisen, und wobei die lokalen individuellen Zeitbestimmungen der Spannungsmesseinrichtung und der zumindest einen Strommesseinrichtung auf eine globale Referenzzeit des Systems abstimmbar sind.

Hierdurch kann gewährleistet werden, dass trotz der Messungen der Versorgungsspannung durch die Spannungsmesseinrichtung und des Verbraucherstroms durch die zumindest eine Strommesseinrichtung an verschiedenen Stellen im System beide Messungen zeitlich aufeinander abgestimmt werden können, um so ein aussagekräftiges Ergebnis für die Leistungsbestimmung auf Basis der Messergebnisse für Spannung und Strom der Spannungsmesseinrichtung und der Strommesseinrichtung zu erzielen.

Nach einer Ausführungsform umfasst das System eine Mehrzahl von Verbrauchern, die jeweils mit der Spannungsquelle verbunden sind.

Hierdurch wird der technische Vorteil erreicht, dass eine verteilte Leistungsbestimmung für eine Mehrzahl von Verbrauchern erreicht wird.

Nach einem dritten Aspekt der Erfindung wird ein Computerprogramm bereitgestellt, umfassend Befehle, die bei der Ausführung des Computerprogramms durch einen Computer oder die Steuerungseinheit diese veranlassen, ein Verfahren zur verteilten elektrischen Leistungsbestimmung auszuführen.

Nach einem vierten Aspekt der Erfindung wird ein maschinenlesbares Speichermedium bereitgestellt, auf dem das erfindungsgemäß Computerprogramm gespeichert ist.

Die Erfindung wird im Folgenden anhand von bevorzugten Ausführungsformen näher erläutert. Hierbei zeigen:

Fig. 1 ein Ablaufdiagramm eines Verfahrens zur verteilten elektrischen Leistungsbestimmung gemäß einer ersten Ausführungsform;

Fig. 2 ein Ablaufdiagramm des Verfahrens zur verteilten elektrischen Leistungsbestimmung gemäß einer weiteren Ausführungsform;

Fig. 3 eine schematische Abbildung einer Spektralanalyse des Verfahrens zur verteilten elektrischen Leistungsbestimmung gemäß einer weiteren Ausführungsform;

Fig. 4 eine schematische Abbildung einer Versorgungsspannung und eines Verbraucherstroms des Verfahrens zur verteilten elektrischen Leistungsbestimmung gemäß einer weiteren Ausführungsform;

Fig. 5 ein Ablaufdiagramm des Verfahrens zur verteilten elektrischen Leistungsbestimmung gemäß einer weiteren Ausführungsform;

Fig. 6 eine schematische Abbildung eines Systems zur verteilten elektrischen Leistungsbestimmung gemäß einer Ausführungsform;

Fig. 7 eine schematische Abbildung eines Ethernet-Netzwerkaufbaus mit einem Ethernet-Koppler und einer Spannungsmesseinrichtung und zumindest einer Strommesseinrichtung, die ringförmig an den Ethernet-Koppler angeschlossen sind und die eine Verarbeitung eines Ethernet-Telegramms im Durchlauf ausführen, gemäß einer Ausführungsform;

Fig. 8 eine schematische Abbildung des Ethernet-Netzwerkbaus in Fig. 7 gemäß einer weiteren Ausführungsform;

Fig. 9 eine schematische Abbildung eines ersten Datenpakets des Verfahrens zur verteilten elektrischen Leistungsbestimmung gemäß einer weiteren Ausführungsform; und

Fig. 10 eine schematische Abbildung eines Speichermediums mit einem Computerprogramm zur Ausführung des Verfahrens zur verteilten elektrischen Leistungsbestimmung.

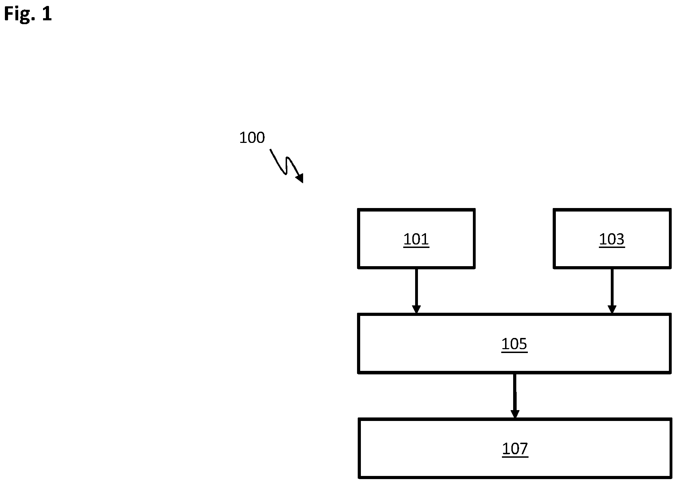

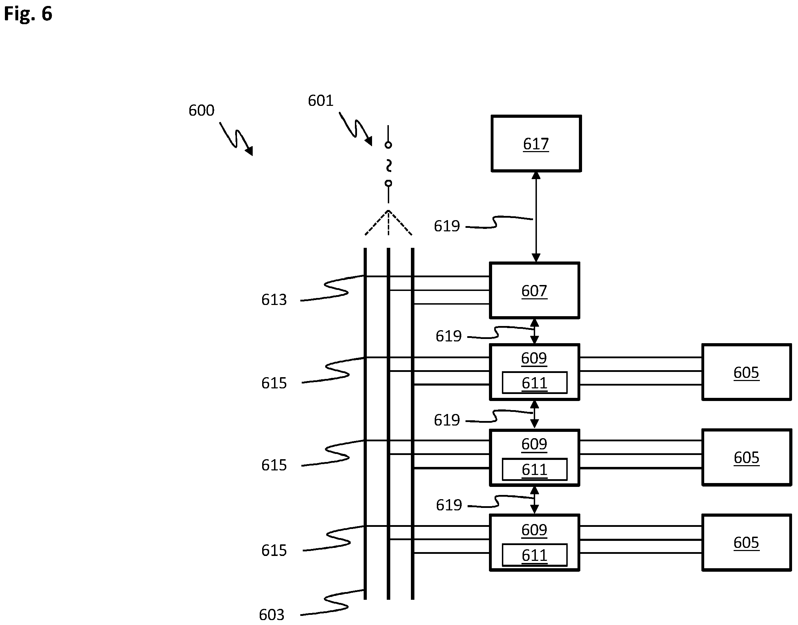

Fig. 1 zeigt ein Ablaufdiagramm des Verfahrens 100 zur verteilten elektrischen Leistungsbestimmung zumindest eines in Fig. 6 näher gezeigten Verbrauchers 605 gemäß einer ersten Ausführungsform. Zum besseren Verständnis wird das Verfahren stets im Zusammenhang mit dem Aufbau entsprechend Fig. 6 beschrieben.

Der Verbraucher 605 ist über einen Spannungspfad 603 mit einer Spannungsquelle 601 verbunden. Eine Spannungsmesseinrichtung 607 bestimmt eine Versorgungsspannung U der Spannungsquelle 601 an einem Spannungsmesspunkt 613 auf dem Spannungspfad 603 und zumindest eine Strommesseinrichtung 609 bestimmt einen Verbraucherstrom I des Verbrauchers 605 an einem Strommesspunkt 615 auf dem Spannungspfad 603.

Gemäß Fig. 1 umfasst das Verfahren 100 zur verteilten elektrischen Leistungsbestimmung die Verfahrensschritte: Aufnehmen von Spannungsmesswerten DPU der Versorgungsspannung U durch die Spannungsmesseinrichtung 607 zur Bestimmung eines Spannungsverlaufs TCU der Versorgungsspannung U in einem Spannungsmessschritt 101, Aufnehmen von Strommesswerten DPI eines Verbraucherstroms I des zumindest einen Verbrauchers 605 durch die zumindest eine Strommesseinrichtung 609 zur Bestimmung eines Stromverlaufs TCI des Verbraucherstroms I in einem Strommessschritt 103, Analysieren der Spannungsmesswerte DPU der Versorgungsspannung U und/oder der Strommesswerte DPI des Verbraucherstroms I mit einer Analysefunktion AF in einem Analyseschritt 105, um Spannungskenngrößen AFPU des Spannungsverlaufs TCU der Versorgungsspannung U und/oder Stromkenngrößen AFPI des Stromverlaufs TCI des Verbraucherstroms I zu bestimmen, und Ermitteln zumindest eines Leistungswerts L unter Berücksichtigung der Spannungskenngrößen AFPU des Spannungsverlaufs TCU der Versorgungsspannung U und/oder der Stromkenngrößen AFPI des Stromverlaufs TCI der Verbraucherstroms I in einem Leistungswertermittlungsschritt 107.

Zur verteilten Bestimmung einer elektrischen Leistung von zumindest einem elektrischen Verbraucher 605 werden in dem Spannungsmessschritt 101 durch die Spannungsmesseinrichtung 607 Spannungsmesswerte DPU der Versorgungsspannung U des Verbrauchers 605 aufgenommen. Die Spannungsmesseinrichtung 607 nimmt hierbei die Spannungsmesswerte DPU an einem Spannungsmesspunkt 613 auf.

In dem Strommessschritt 103, der zeitlich simultan zum Spannungsmessschritt 101 durchgeführt werden kann, werden durch die Strommesseinrichtung 609 an einem vom Spannungsmesspunkt 613 verschiedenen Strommesspunkt 615 Strommesswerte DPI des Verbraucherstroms I des zumindest einen Verbrauchers 605 aufgenommen.

Zur verteilten elektrischen Leistungsbestimmung werden somit an zwei räumlich voneinander getrennten Messpunkten Spannungs- und Strommessungen durchgeführt.

Die Aufnahme der Spannungsmesswerte DPU im Spannungsmessschritt 101 und die Aufnahme der Strommesswerte DPI im Strommessschritt 103 durch die Spannungsmesseinrichtung 607 und die Strommesseinrichtung 609 kann die Aufnahme einer Vielzahl von Spannungsmesswerten DPU im Spannungsmessschritt 101 und die Aufnahme einer Vielzahl von Strommesswerten DPI im Strommessschritt 103 umfassen. Die Aufnahme der Messwerte kann kontinuierlich stattfinden. Sie kann aber auch auf einen vorbestimmten Messzeitraum beschränkt sein. Vorzugsweise werden die Spannungsmesswerte DPU und Strommesswerte DPI während aufeinander abgestimmten ersten Zeitintervallen T1 und zweiten Zeitintervallen T2 aufgenommen, wobei in den ersten Zeitintervallen T1 Spannungsmesswerte DPU und in den zweiten Zeitintervallen T2 Strommesswerte DPI aufgenommen werden.

Durch die Aufnahme der Spannungsmesswerte DPU im Spannungsmessschritt 101 und Strommesswerte DPI im Strommessschritt 103 können Spannungsverläufe TCU der Versorgungsspannung U und Stromverläufe TCI des Verbraucherstroms I erstellt werden. Die Spannungsverläufe TCU und Stromverläufe TCI beschreiben hierbei die zeitliche Entwicklung der Versorgungsspannung U und des Verbraucherstroms I und sind durch die jeweils aufgenommenen Spannungsmesswerte DPU und Strommesswerte DPI definiert. Die Spannungsverläufe TCU und Stromverläufe TCI können durch eine entsprechend gewählte Analysefunktion AF beschrieben werden.

Nach Aufnahme der Spannungsmesswerte DPU im Spannungsmessschritt 101 und nach Aufnahme der Strommesswerte DPI im Strommessschritt 103 werden in dem Analyseschritt 105 die Spannungsmesswerte DPU und/oder die Strommesswerte DPI einer Datenanalyse unterzogen. Es können entweder die Spannungsmesswerte DPU oder die Strommesswerte DPI analysiert werden. Abweichend können auch die Spannungsmesswerte DPU und die Strommesswerte DPI analysiert werden. Welche der beiden Datensätze analysiert werden, kann davon abhängig gemacht werden, welche der Spannungsmesswerte DPU und der Strommesswerte DPI zu einer Bestimmung zumindest eines Leitungswerts L in einem weiteren Verlauf des Verfahrens 100 an eine Prozessoreinheit 611 übermittelt werden sollen.

Es können die Spannungsmesswerte DPU oder die Strommesswerte DPI, die zur Leistungsbestimmung von der Spannungsmesseinrichtung 607 oder der Strommesseinrichtung 609 übermittelt werden sollen, im Analyseschritt 105 analysiert werden. Nichtanalysierte Spannungsmesswerte DPU oder Strommesswerte DPI werden nicht übermittelt.

Die Analyse der Spannungsmesswerte DPU wird von der Spannungsmesseinrichtung 607 im Analyseschritt 105 durchgeführt, während die Strommesswerte DPI von der Strommesseinrichtung 609 im Analyseschritt 105 analysiert werden.

Die Analyse der Spannungsmesswerte DPU und/oder der Strommesswerte DPI umfasst eine Analyse der jeweiligen Messwerte mit einer ausgewählten Analysefunktion AF im Analyseschritt 105. Eine Analysefunktion AF ist hierbei eine mathematische Funktion oder eine mathematische Handlungsvorschrift, die geeignet ist, aus den

Spannungsmesswerten DPU und/oder den Strommesswerten DPI Spannungskenngrößen AFPU und Stromkenngrößen AFPI der Spannungsverläufe TCU und der Stromverläufe TCI zu bestimmen.

Spannungskenngrößen AFPU und Stromkenngrößen AFPI sind hierbei Parameter der Analysefunktion AF, die bei der Analyse entsprechend variiert werden, um die Analysefunktion AF an die Spannungsmesswerte DPU und/oder an die Strommesswerte DPI anzunähern. Derartige Parameter sind damit geeignet, die Spannungsverläufe TCU und die Stromverläufe TCI der jeweiligen Spannungsmesswerte DPU und der Strommesswerte DPI unter Berücksichtigung der jeweiligen Analysefunktion AF eindeutig zu charakterisieren.

Die Analysefunktion AF ist bei Analyse der Spannungsmesswerte DPU und der Strommesswerte DPI identisch. Auch sind die Paramater der Analysefunktion AF, die während des Analyseprozesses variiert werden, für beide Analysen der Spannungsmesswerte DPU und der Strommesswerte DPI identisch.

Die durch die jeweiligen Analysen im Analyseschritt 105 erhaltenen Spannungskenngrößen AFPU und Stromkenngrößen AFPI sind lediglich unterschiedliche Zahlenwerte derselben Parameter.

Die Wahl der Parameter kann von der Wahl der Analysefunktion AF abhängen.

Die Spannungskenngrößen AFPU und Stromkenngrößen AFPI sind aber nicht auf Parameter der Analysefunktion AF beschränkt. Alternativ können die Spannungskenngrößen AFPU und Stromkenngrößen AFPI auch aus anderen Größen ermittelt werden, die mittels der Anwendung der Analysefunktion AF auf die Spannungsmesswerte DPU und/oder Strommesswerte DPI bestimmt werden können. Voraussetzung ist jedoch, dass aus den Spannungskenngrößen AFPU und Stromkenngrößen AFPI in eindeutiger Weise die jeweiligen Spannungsmesswerte DPU und Strommesswerte DPI wiederherstellbar sind. Dies kann erfordern, dass die jeweilige durch die Analysefunktion AF ausgedrückte Handlungsvorschrift eindeutig umkehrbar ist. Die Anzahl und die technische Bedeutung der Spannungskenngrößen AFPU und der Stromkenngrößen AFPI hängen direkt mit der Wahl der Analysefunktion AF zusammen und können zwischen verschiedenen Analysefunktionen AF stark variieren.

Nach Analyse der Spannungsmesswerte DPU und/oder der Strommesswerte DPI im Analyseschritt 105 wird in dem Leistungswertermittlungsschritt 107 zumindest ein Leistungswert L unter Berücksichtigung der im Analyseschritt 105 erstellten Spannungskenngrößen AFPU und/oder Stromkenngrößen AFPI ermittelt.

Hierzu werden wenigstens die Spannungskenngrößen AFPU von der Spannungsmesseinrichtung 607 oder die Stromkenngrößen AFPI von der Strommesseinrichtung 609 an eine Prozessoreinheit 611 übermittelt, mittels der die Leistungsbestimmung gemäß dem Leistungswertermittlungsschritt 107 durchgeführt wird.

Vorzugsweise werden im Analyseschritt 105 diejenigen Messwerte, sprich die Spannungsmesswerte DPU oder die Strommesswerte DPI oder beide, analysiert, die an die Prozessoreinheit 611 übermittelt werden sollen.

Die Prozessoreinheit 611 kann in der Spannungsmesseinrichtung 607 ausgebildet sein. In diesem Fall werden im Analyseschritt 105 die Strommesswerte DPI analysiert und es werden Stromkenngrößen AFPI bestimmt, um diese von der Strommesseinrichtung 609 an die Spannungsmesseinrichtung 607 und die darin ausgebildete Prozessoreinheit 611 zu übermitteln.

Die Prozessoreinheit 611 kann aber auch in der zumindest einen Strommesseinrichtung 609 ausgebildet sein. In diesem Fall werden im Analyseschritt 105 die Spannungsmesswerte DPU analysiert und die Spannungskenngrößen AFPU bestimmt, um diese dann von der Spannungsmesseinrichtung 607 an die Strommesseinrichtung 609 und die darin ausgebildete Prozessoreinheit 611 zu übermitteln.

Abweichend kann die Prozessoreinheit 611 jedoch ebenfalls eine externe Prozessoreinheit 611 sein, die weder in der Spannungsmesseinrichtung 607 noch in der Strommesseinrichtung 609 ausgebildet ist. In diesem Fall werden im Analyseschritt 105 sowohl die Spannungsmesswerte DPU als auch die Strommesswerte DPI analysiert und entsprechend die Spannungskenngrößen AFPU und die Stromkenngrößen AFPI bestimmt und sowohl die Spannungskenngrößen AFPU als auch die Stromkenngrößen AFPI an die externe Prozessoreinheit 611 übermittelt.

In dem Leistungswertermittlungsschritt 107 wird zumindest ein Leistungswert L unter Berücksichtigung der Spannungskenngrößen AFPU und/oder Stromkenngrößen AFPI ermittelt.

Für den Fall, dass die Prozessoreinheit 611 in der Spannungsmesseinrichtung 607 oder der Strommesseinrichtung 609 ausgebildet und im Analyseschritt 105 nur die Spannungsmesswerte DPU oder die Strommesswerte DPI analysiert und die entsprechenden Spannungskenngrößen AFPU oder Stromkenngrößen AFPI bestimmt und an die Prozessoreinheit 611 übermittelt wurden, können zur Ermittlung des zumindest einen Leistungswerts L im Leistungswertermittlungsschritt 107 in der Prozessoreinheit 611 die jeweils nichtanalysierten Spannungsmesswerte DPU oder Strommesswerte DPI mit der Analysefunktion AF analysiert und die entsprechenden Spannungskenngrößen AFPU oder Stromkenngrößen AFPI bestimmt werden.

Ist die Prozessoreinheit 611 beispielsweise in der Spannungsmesseinrichtung 607 ausgebildet und sind im Analyseschritt 105 die Strommesswerte DPI analysiert und die Stromkenngrößen AFPI bestimmt worden, um diese von der Strommesseinrichtung 609 an die Spannungsmesseinrichtung 607 und die darin ausgebildete Prozessoreinheit 611 zu übermitteln, können im Leistungswertermittlungsschritt 107 die Spannungsmesswerte DPU analysiert und die Spannungskenngrößen AFPU bestimmt werden.

Für den Fall, dass die Prozessoreinheit 611 in der Strommesseinrichtung 609 ausgebildet ist und im Analyseschritt 105 die Spannungsmesswerte DPU analysiert und die Spannungskenngrößen AFPU bestimmt worden sind, können analog im Leistungswertermittlungsschritt 107 die Strommesswerte DPI analysiert und die Stromkenngrößen AFPI bestimmt werden.

Die Ermittlung des zumindest einen Leistungswerts L durch die Prozessoreinheit 611 findet dann auf Basis der Spannungskenngrößen AFPU und der Stromkenngrößen AFPI in dem Leistungswertermittlungsschritt 107 statt.

Hierzu können beispielsweise die Spannungskenngrößen AFPU und die Stromkenngrößen AFPI miteinander multipliziert werden. Die Art und Weise der Bestimmung des zumindest einen Leistungswerts L kann aber von der Wahl der Spannungskenngrößen AFPU und der Stromkenngrößen AFPI abhängig sein.

Alternativ kann auch eine Rücktransformation der übertragenen Spannungskenngrößen AFPU oder Stromkenngrößen AFPI in die entsprechenden Spannungsmesswerte DPU oder Strommesswerte DPI durch die Prozessoreinheit 611 erfolgen.

Ist beispielsweise die Prozessoreinheit 611 in der Strommesseinrichtung 609 ausgebildet und wurden demzufolge im Analyseschritt 105 die Spannungsmesswerte DPU analysiert und die Spannungskenngrößen AFPU bestimmt und an die Prozessoreinheit 611 übermittelt, während die Strommesswerte DPI im Analyseschritt 105 nicht analysiert wurden, können im Leistungswertermittlungsschritt 107 von der Prozessoreinheit 611 die Spannungskenngrößen AFPU in die spannungsmesswerte DPU zurücktransformiert werden.

Die Ermittlung des zumindest einen Leistungswerts L findet dann auf Basis der Spannungsmesswerte DPU und der Strommesswerte DPI statt.

Eine Rücktransformation von Spannungskenngrößen AFPU oder Stromkenngrößen AFPI in entsprechende Spannungsmesswerte DPU oder Strommesswerte DPI kann beispielsweise durch eine Anwendung einer Umkehrfunktion der Analysefunktion AF oder durch eine umkehrende Handlungsvorschrift zu der durch die Analysefunktion AF bestimmten mathematischen Handlungsvorschrift auf die jeweiligen Spannungskenngrößen AFPU oder Stromkenngrößen AFPI erfolgen.

Für den Fall, dass die Prozessoreinheit 611 als externe Prozessoreinheit 611 ausgebildet ist, liegen der Prozessoreinheit 611 vorzugsweise die Spannungskenngrößen AFPU und Stromkenngrößen AFPI vor, da diese zur Übermittlung von der Spannungsmesseinrichtung 607 beziehungsweise von der Strommesseinrichtung 609 an die Prozessoreinheit 611 im Analyseschritt 105 aus den entsprechenden Spannungsmesswerten DPU und den Strommesswerten DPI bestimmt worden sind.

Die Ermittlung des zumindest einen Leistungswert L kann somit auf Basis der übermittelten Spannungskenngrößen AFPU und der Stromkenngrößen AFPI durchgeführt werden.

Alternativ können aber auch Rücktransformationen der Spannungskenngrößen AFPU und Stromkenngrößen AFPI in die entsprechenden Spannungsmesswerte DPU und die Strommesswerte DPI vorgenommen werden und die Ermittlung des zumindest einen Leistungswerts L auf Basis der Spannungsmesswerte DPU und der Strommesswerte DPI durchgeführt werden.

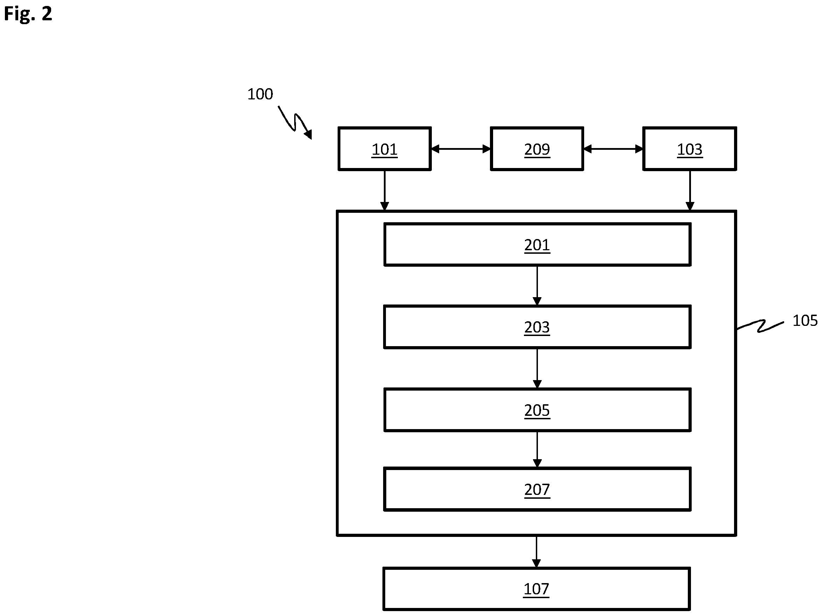

Fig. 2 zeigt ein Ablaufdiagramm des Verfahrens 100 zur verteilten elektrischen Leistungsbestimmung gemäß einer weiteren Ausführungsform.

Sofern nicht anderslautend beschrieben, umfasst das Verfahren 100 in Fig. 2 die unter Fig. 1 beschriebenen Schritte.

Gemäß Fig. 2 werden in einem Synchronisationsschritt 209 die Spannungsmesseinrichtung 607 und die Strommesseinrichtung 609 auf eine Referenzzeit synchronisiert.

Das Ziel der Synchronisation der Spannungsmesseinrichtung 607 und der zumindest einen Strommesseinrichtung 609 im Synchronisationsschritt 209 ist es, die Aufnahme der Spannungsmesswerte DPU durch die Spannungsmesseinrichtung 607 im Spannungsmessschritt 101 und die Aufnahme der Strommesswerte DPI durch die Strommesseinrichtung 609 im Strommessschritt 103 zeitlich aufeinander abzustimmen. Auf diese Weise kann gewährleistet werden, dass die an unterschiedlichen Spannungsmesspunkten 613 und Strommesspunkten 615 aufgenommenen Spannungsmesswerte DPU und Strommesswerte DPI für eine Bestimmung des zumindest einen Leistungswerts L verwendet werden können und ein aussagekräftiges Ergebnis erzielt werden kann.

Zur Synchronisation gemäß dem Synchronisationsschritt 209 können die Spannungsmesseinrichtung 607 und die Strommesseinrichtung 609 jeweils eine individuelle lokale Zeitbestimmung aufweisen. Beispielsweise können die Spannungsmesseinrichtung 607 und die zumindest eine Strommesseinrichtungen 609 jeweils eine eigene unabhängige lokale Uhr aufweisen, die eine individuelle unabhängige Zeitbestimmung für die jeweilige Messeinrichtung ermöglicht.

Die lokalen Uhren der Spannungsmesseinrichtung 607 und der Strommesseinrichtung 609 können dann zur Synchronisation gemäß dem Synchronisationsschritt 209 in Relation zu einer von den lokalen Uhren unabhängigen globalen Referenzuhr gesetzt werden, indem jeweils die Abweichungen der lokalen Uhren von der globalen Referenzuhr bestimmt werden.

Alternativ kann auch eine der lokalen Uhren der Spannungsmesseinrichtung 607 und der Strommesseinrichtung 609 als globale Uhr bestimmt werden. Eine Synchronisation gemäß dem Synchronisationsschritt 209 erfolgt in diesem Fall analog, indem die lokalen Zeiten der lokalen Uhren in Relation zu der Referenzzeit der Referenzuhr gesetzt werden.

Hierzu können beispielsweise von der Referenzuhr Zeitsignale an die lokalen Uhren gesendet werden, mittels derer die lokalen Uhren die lokal bestimmte Zeit in Relation zur Referenzzeit setzen können.

Gemäß Fig. 2 umfasst die Analyse der Spannungsmesswerte DPU und/oder der Strommesswerte DPI im Analyseschritt 105 das Durchführen einer Spektralanalyse in einem Spektralanalyseschritt 201.

Die Spektralanalyse der Spannungsmesswerte DPU und/oder der Strommesswerte DPI im Spektralanalyseschritt 201 wird insbesondere durch eine Fourier-Analyse beziehungsweise eine diskrete Fouriertransformation realisiert.

Die Fourier-Analyse, insbesondere die diskrete Fouriertransformation, der Spannungsmesswerte DPU und/oder der Strommesswerte DPI ermöglicht eine Zerlegung der durch die Spannungsmesswerte DPU dargestellten Versorgungsspannung U und/oder des durch die Strommesswerte DPI dargestellten Verbraucherstroms I in periodische Bestandteile der Versorgungsspannung U und des Verbraucherstroms I mit Grundfrequenzen und Oberfrequenzen.

Ferner erlaubt die Fourier-Analyse, insbesondere die diskrete Fouriertransformation, eine Bestimmung der jeweiligen periodischen Bestandteile mit Spannungsgrundfrequenz Uo, Stromgrundfrequenzen $I_0$, Spannungsoberfrequenzen $U_1,...,U_n$, und Stromoberfrequenzen $I_1,...,I_n$ der zu analysierenden Versorgungsspannung U und/oder dem zu analysierenden Verbraucherstrom I.

Hierzu lassen sich aus der Fourier-Analyse Spannungsspektralwerte SDUo und/oder Stromspektralwerte $SDI_0$ der Spannungsgrundfrequenz Uo und/oder der Stromgrundfrequenz $I_0$ und Spannungsspektralwerte $SDU_1,...,SDU_n$ und Stromspektralwerte $SDI_1,...,SDI_n$ der Spannungsoberfrequenzen $U_1,...,U_n$, und der Stromoberfrequenz $I_1,...,I_n$ sowie der Spannungsgleichanteil $SDU_{n+1}$ der Versorgungsspannung U und der Stromgleichanteil $SDI_{n+1}$ des Verbraucherstroms I bestimmen.

Die Spannungsspektralwerte SDUo, $SDU_1,...,SDU_n$, und der Spannungsgleichanteil $SDU_{n+1}$ und die Stromspektralwerte $SDI_0$, $SDI_1,...,SDI_n$, und der Stromgleichanteil $SDI_{n+1}$ sind hierbei Zahlenwerte der anteilsmäßigen Verteilung der jeweiligen periodischen Bestandteile der periodischen Versorgungsspannung U inklusive des Spannungsgleichanteils und des periodischen Verbraucherstroms I inklusive des Stromgleichanteils darstellen.

Darüber hinaus lassen sich Spannungsphasenwinkel $\phi_{U1},...,\phi_{Un}$ der Spannungsoberfrequenzen $U_1,...,U_n$, und Stromphasenwinkel $\phi_{I1},...,\phi_{In}$ der Stromoberfrequenzen $I_1,...,I_n$ in Relation zur Spannungsgrundfrequenz Uo, und der Stromgrundfrequenz $I_0$ bestimmen.

Für eine nähere Beschreibung der Durchführung einer Fourier-Analyse beziehungsweise einer diskreten Fourier-Transformation wird auf entsprechende Ausführungen aus dem Stand der Technik verwiesen.

In der beschriebenen Ausführungsform kann beispielsweise die Handlungsvorschrift der diskreten Fouriertransformation die Analysefunktion AF sein.

In einem Spektrumerstellungsschritt 203 wird als Ergebnis der Spektralanalyse beziehungsweise der Fourier-Analyse der Spannungsmesswerte DPU und/oder der Strommesswerte DPI ein Spannungsfrequenzspektrum SDU der Versorgungsspannung U und/oder ein Stromfrequenzspektrum SDI des Verbraucherstroms I erstellt.

In dem jeweiligen Spannungsfrequenzspektrum SDU der Versorgungsspannung U oder dem Stromfrequenzspektrum SDI des Verbraucherstroms I ist die anteilsmäßige Zusammensetzung der Versorgungsspannung U oder des Verbraucherstroms I aus periodischen Bestandteilen unterschiedlicher Frequenzen dargestellt.

Die Versorgungsspannung U oder der Verbraucherstrom I können über eine Linearkombination von Sinus- oder Kosinus-Funktionen der im jeweiligen Spannungsfrequenzspektrum SDU oder Stromfrequenzspektrum SDI ermittelten Frequenzen dargestellt werden, wobei die im Spannungsfrequenzspektrum SDU oder Stromfrequenzspektrum SDI dargestellten Anteile der jeweiligen Frequenzen als Faktoren der Sinus- oder Kosinus-Funktionen mit der jeweiligen Frequenz dienen.

In einer Fourier-Analyse wird eine derartige Linearkombination durch eine entsprechende Fourier-Reihe dargestellt.

In einem Reduktionsschritt 205 wird das Spannungsfrequenzspektrum SDU der Versorgungsspannung U und/oder das Stromfrequenzspektrum SDI des Verbraucherstroms I auf die Frequenzen einer Spannungsgrundfrequenz Uo und/oder Stromgrundfrequenz $I_0$ und der ersten n Spannungsoberfrequenzen $U_1,...,U_n$ und/oder der ersten n Stromoberfrequenzen $I_1,...,I_n$ reduziert. Zusätzlich werden der Spannungsgleichanteil $SDU_{n+1}$ und/oder der Stromgleichanteil $SDI_{n+1}$ bestimmt.

Der Spannungsgleichanteil $SDU_{n+1}$ und der Stromgleichanteil $SDI_{n+1}$ stellen hierbei das arithmetische Mittel der periodischen Versorgungsspannung U und des periodischen Verbraucherstroms I dar.

Die Spannungsgrundfrequenz Uo, die Stromgrundfrequenz $I_0$, die ersten n Spannungsoberfrequenzen $U_1,...,U_n$ und die ersten n Stromoberfrequenzen $I_1,...,I_n$ stellen die anteilsmäßig dominanten Bestandteile des Spannungsfrequenzspektrums SDU der Versorgungsspannung U und des Stromfrequenzspektrums SDI des Verbraucherstroms I dar. Bestandteile mit anderen Frequenzen können hingegen vernachlässigt werden.

Die Bestandteile der Spannungsgrundfrequenz Uo, der Stromgrundfrequenz $I_0$, der ersten n Spannungsoberfrequenzen $U_1,...,U_n$ und der ersten n Stromoberfrequenzen $I_1,...,I_n$ und des Spannungsgleichanteils $SDU_{n+1}$ und des Stromgleichanteils $SDI_{n+1}$ sind damit ausreichend in einer wie oben beschriebenen Linearkombination den Spannungsverlauf TCU der Versorgungsspannung U oder den Stromverlauf TCI des Verbraucherstroms I zu beschreiben.

Darüber hinaus werden Spannungsphasenwinkel $\phi_{U1},...,\phi_{Un}$ der ersten n Oberschwingungen mit den ermittelten Spannungsoberfrequenzen $U_1,...,U_n$ zur Grundschwingung mit der Spannungsgrundfrequenz Uo der Versorgungsspannung U und/oder entsprechende Stromphasenwinkel $\phi_{I1},...,\phi_{In}$ der ersten n Oberschwingungen mit den ermittelten Stromoberfrequenzen $I_1,...,I_n$ zur Grundschwingung mit der Stromgrundfrequenz $I_0$ des Verbraucherstroms I ermittelt.

In einem Spektralwertidentifikationsschritt 207 werden daraufhin die Spannungsspektralwerte SDUo der Spannungsgrundfrequenz Uo, die Spannungsspektralwerte $SDU_1,...,SDU_n$ der ersten n Spannungsoberfrequenzen $U_1,...,U_n$ und die entsprechenden Spannungsphasenwinkel $\phi_{U1},...,\phi_{Un}$ der Versorgungsspannung U als Spannungskenngrößen AFPU und die Stromspektralwerte $SDI_0$ der Stromgrundfrequenz $I_0$, die Stromspektralwerte $SDI_1,...,SDI_n$ der ersten n Stromoberfrequenzen $I_1,...,I_n$ und die entsprechenden Stromphasenwinkel $\phi_{I1},...,\phi_{In}$ des Verbraucherstroms I als Stromkenngrößen AFPI identifiziert.

Zusätzlich werden der Spannungsgleichanteil $SDU_{n+1}$ als weitere Spannungskenngröße AFPU und der Stromgleichanteil $SDI_{n+1}$ als weitere Stromkenngröße AFPI identifiziert.

Mittels der wie oben beschriebenen Linearkombinationen von Sinus- oder Kosinus-Funktionen der Spannungsgrundfrequenz Uo und der ersten n Spannungsoberfrequenzen $U_1,...,U_n$ und des Spannungsgleichanteils $SDU_{n+1}$ beziehungsweise der Stromgrundfrequenz $I_0$ und der ersten n Stromoberfrequenzen $I_1,...,I_n$ und des Stromgleichanteils $SDI_{n+1}$ können mit den entsprechenden Spannungsspektralwerten SDUo,... ,$SDU_n$ für die Spannungsgrundfrequenz Uo und die Spannungsoberfrequenzen $U_1,...,U_n$ und mit dem Spannungsgleichanteil $SDU_{n+1}$ sowie mit den Stromspektralwerten $SDI_0,...,SDI_n$ für die Stromgrundfrequenz $I_0$ und die Stromoberfrequenzen $I_1,...,I_n$ und mit dem Stromgleichanteil $SDI_{n+1}$ als Faktoren der Linearkombinationen der Spannungsverlauf TCU der Versorgungsspannung U und der Stromverlauf TCI des Verbraucherstroms I wiedergegeben werden.

Die Anzahl der Spannungsoberfrequenzen $U_1,...,U_n$ oder Stromoberfrequenzen $I_1,...,I_n$, die bei der Analyse der Versorgungsspannung U oder des Verbraucherstroms I berücksichtigt werden, ist variabel und je nach Anforderung beliebig wählbar. Eine höhere Anzahl berücksichtigter Oberfrequenzen kann zu einer höheren Genauigkeit der Analyse führen.

Nach Identifikation der Spannungsspektralwerte SDUo für die Spannungsgrundfrequenz Uo und der Spannungsspektralwerte $SDU_1,...,SDU_n$ für die ersten n Spannungsoberfrequenzen $U_1,...,U_n$, und des Spannungsgleichanteils $SDU_{n+1}$ als Spannungskenngrößen AFPU und/oder der Identifikation der Stromspektralwerte $SDI_0$ für die Stromgrundfrequenz $I_0$ und der Stromspektralwerte $SDI_1,...,SDI_n$ für die ersten n Stromoberfrequenzen $I_1,...,I_n$, und des Stromgleichanteil $SDI_{n+1}$ als Stromkenngrößen AFPI, werden diese Kenngrößen in dem Leistungswertermittlungsschritt 107 zu Ermittlung des zumindest einen Leistungswertes L verwendet.

Abhängig davon, welche der Spannungsmesswerte DPU oder der Strommesswerte DPI mittels der Spektralanalyse im Spektralanalyseschritt 201 analysiert worden sind, sieht die Ermittlung des zumindest einen Leistungswerts L gemäß dem Leistungswertermittlungsschritt 107 eine weitere Analyse der jeweils bis dahin nichtanalysierten Spannungsmesswerte DPU oder Strommesswerte DPI mittels der oben beschriebenen Spektralanalyse durch die Prozessoreinheit 611 im Spektralanalyseschritt 201 vor.

Nach erfolgreicher Bestimmung der Spannungskenngrößen AFPU oder Stromkenngrößen AFPI durch die Analyse der bis dahin nichtanalysierten Spannungsmesswerte DPU oder Strommesswerte DPI kann der zumindest eine Leistungswert L auf Basis der Spannungskenngrößen AFPU und Stromkenngrößen AFPI ermittelt werden.

Sind beispielsweise im Analyseschritt 105 die Spannungsmesswerte DPU analysiert und die Spannungskenngrößen AFPU bestimmt, die Strommesswerte DPI jedoch nicht analysiert, werden in dem folgenden Leistungswertermittlungsschritt 107 durch die Prozessoreinheit die Strommesswerte DPI analysiert und die Stromkenngrößen AFPI bestimmt.

Sind im Analyseschritt 105 die Strommesswerte DPI analysiert und die Stromkenngrößen AFPI bestimmt, die Spannungsmesswerte DPU jedoch nicht analysiert, ist entsprechend analog zu verfahren.

Sind im Analyseschritt 105 sowohl die Spannungsmesswerte DPU als auch die Strommesswerte DPI analysiert und die Spannungskenngrößen AFPU und die Stromkenngrößen AFPI bestimmt, können im Leistungswertermittlungsschritt 107 die Spannungskenngrößen AFPU und die Stromkenngrößen AFPI zur Bestimmung des zumindest einen Leistungswerts L herangezogen werden.

Hierzu lassen sich beispielsweise die Spannungskenngrößen AFPU, insbesondere die Spannungsspektralwerte $SDU_0,...$ ,$SDU_n$ für die Spannungsgrund-frequenz Uo und die Spannungsoberfrequenzen $U_1,...,U_n$, und der Spannungsgleichanteil $SDU_{n+1}$ zu einem Spannungsvektor U zusammenfassen, der die Spannungsspektralwerte der Spannungsgrundfrequenz Uo und der ersten n Spannungsoberfrequenzen $U_1,...,U_n$ und den Spannungsgleichanteil $SDU_{n+1}$ der Versorgungsspannung U umfasst, wobei der Index T den transponierten Vektor kennzeichnet.

$$\mathbf{U}=[SDU_0,SDU_1,\ldots,SDU_n,SDU_{n+1}]^T$$

Analog lassen sich die Stromkenngrößen AFPI, insbesondere die Stromspektralwerte $SDI_0,...,SDI_n$ der Stromgrundfrequenz $I_0$ und Stromoberfrequenzen $I_1,...,I_n$, und der Stromgleichanteil $SDI_{n+1}$ zu einem Stromvektor I zusammenfassen, der die Stromspektralwerte der Stromgrundfrequenz $I_0$ und der ersten n Stromoberfrequenzen $I_1,...,I_n$ und

den Stromgleichanteil $SDI_{n+1}$ des Verbraucherstroms I umfasst.

$$I=[SDI_0,SDI_1,\ldots,SDI_n,SDI_{n+1}]^\top$$

Aus den beiden Spannungsvektor U und Stromvektor I lässt sich im Folgenden eine Matrix S der Scheinleistung S erstellen, wobei I* den komplex konjugierten Stromvektor I der Stromkenngrößen AFPI beziehungsweise der Harmonischen, sprich der Stromgrundfrequenz $I_0$ und der ersten n Stromoberfrequenzen $I_1,\ldots,I_n$, des Versorgungsstroms I bezeichnet.

$$\underline{S} = U \times I^* = \begin{bmatrix} SDU_0 \cdot SDI_0^* & \cdots & SDU_0 \cdot SDI_{n+1}^* \\ \vdots & \ddots & \vdots \\ SDU_{n+1} \cdot SDI_0^* & \cdots & SDU_{n+1} \cdot SDI_{n+1}^* \end{bmatrix}$$

Hieraus lassen sich sowohl die Wirkleistung P, die Blindleistung Q als auch die Verzerrungsblindleistung D bestimmen.

Die Wirkleistung P ergibt sich aus Summation der Realteile der Diagonale der Matrix S der Scheinleistung, für die die Matrixeinträge $SDU_i \cdot SDI_j^*$ identische Indizes i und j aufweisen, wobei i und j die Zeilen- und Spalteneinträge der Matrix $\underline{S}$ beschreiben, sodass gilt $\Re\{SDU_i \cdot SDI_i^*\}$, $\forall i \leq n + 1$

$$P = \sum_{i=0}^{n+1} \Re\{SDU_i \cdot SDI_i^*\}$$

Die analoge Summation der Imaginärteile der Diagonaleinträge mit identischen Indizes für $SDU_i \cdot SDI_j^*$ ergibt die Blindleistung Q.

$$Q = \sum_{i=0}^{n+1} \Im\{SDU_i \cdot SDI_i^*\}$$

Die Verzerrungsblindleistung D ergibt sich hingegen über eine Summation aller weiteren Matrixeinträge, für die die Indizes für $SDU_i \cdot SDI_j^*$ verschieden sind.

$$D = \sqrt{\sum_{i \neq j; i,j \leq n+1} SDU_i \cdot SDI_j^*}$$

Die Gesamtscheinleistung S erfolgt aus einer Summation der Quadrate der Wirkleitung P, der Blindleistung Q und der Verzerrungsblindleistung D.

$$S = \sqrt{P^2 + Q^2 + D^2}$$

Die Analyse der Spannungsmesswerte DPU und der Strommesswerte DPI auf Basis einer Spektralanalyse, insbesondere einer diskreten Fouriertransformation, ermöglicht folglich die Bestimmung verschiedener Anteile der Gesamtscheinleistung S.

Alternativ ist im Leistungswertermittlungsschritt 107 auch eine Rücktransformation der Spannungskenngrößen AFPU und Stromkenngrößen AFPI in die entsprechenden Spannungsmesswerte DPU und Strommesswerte DPI möglich.

Eine derartige Rücktransformation kann beispielsweise dadurch erzielt werden, dass eine entsprechende Fourier-Rücktransformation der ermittelten Spannungsspektralwerte $SDU_0,\ldots,SDU_n$ für die Grundfrequenz Uo und die Oberfrequenzen $U_1,\ldots,U_n$ der Versorgungspannung U oder der Stromspektralwerte $SDI_0,\ldots,SDI_n$ für die Grundfrequenz $I_0$ und die Oberfrequenzen $I_1,\ldots,I_n$ des Verbraucherstroms I in die entsprechenden Spannungsmesswerte DPU oder Strommesswerte DPI durchgeführt wird. Sind im Analyseschritt 105 Spannungsmesswerte DPU oder Strommesswerte DPI nicht analysiert worden, bleiben diese unverändert.

Eine Ermittlung des zumindest einen Leistungswerts L ist dann unter Berücksichtigung der so erhaltenen Spannungsmesswerte DPU und der Strommesswerte DPI im Leistungsermittlungsschritt 107, beispielsweise durch eine Multiplikation einzelner Spannungsmesswerte DPU und Strommesswerte DPI, ermöglicht.

In einer Ausführungsform kann die diskrete Fouriertransformation als eine schnelle Fouriertransformation durchgeführt werden.

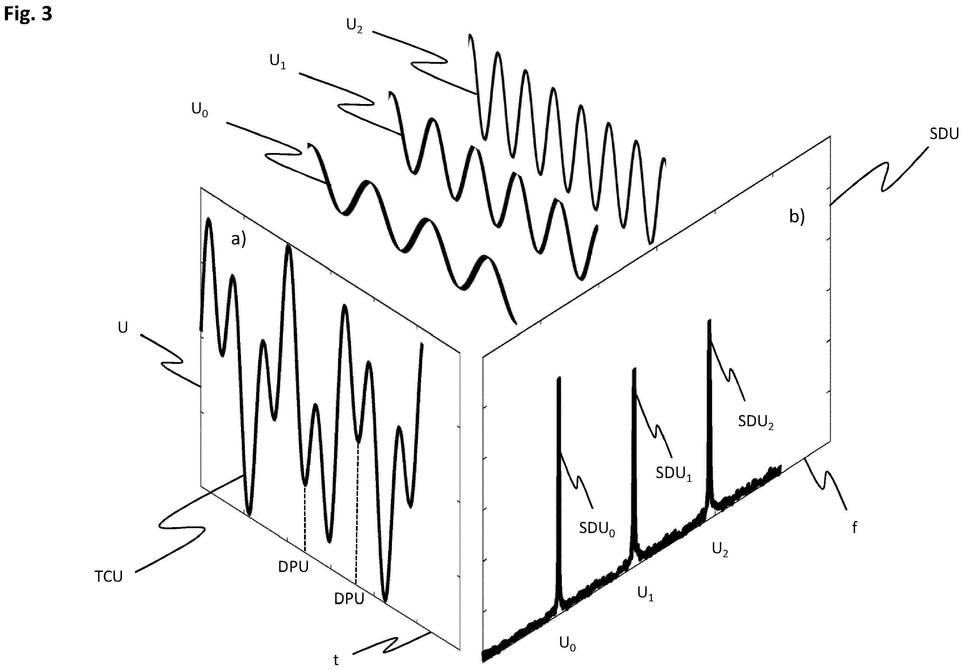

Fig. 3 zeigt eine schematische Abbildung einer Spektralanalyse des Verfahrens 100 zur verteilten elektrischen Leistungsbestimmung gemäß einer weiteren Ausführungsform.

Unter Berücksichtigung der Fig. 3 wird noch einmal in illustrativer Form die Vorgehensweise der oben beschriebenen Spektralanalyse beschrieben.

Fig. 3 ist aus Gründen der Übersichtlichkeit der Darstellung auf die Versorgungsspannung U beschränkt. Das in Fig. 3 Dargestellte lässt sich aber analog auf den Verbraucherstrom I übertragen.

In dem Versorgungsspannung U gegen Zeit t Diagramm, welches auch als Diagramm a) bezeichnet sein kann, ist ein zeitlicher Spannungsverlauf TCU der Versorgungsspannung U dargestellt. Die in dem Diagramm a) dargestellte Kurve dient jedoch lediglich zu illustrativen Zwecken und soll keinen realen zeitlichen Spannungsverlauf TCU einer Versorgungsspannung U darstellen.

Der dargestellte Spannungsverlauf TCU zeigt den, wenn auch nur andeutungsweise erkennbaren, periodischen Verlauf einer Grundschwingung mit Spannungsgrundfrequenz Uo, der jedoch durch Oberschwingungen mit Spannungsoberfrequenzen $U_1,...,U_n$ überlagert und entsprechend verzerrt ist. Die dargestellte Versorgungsspannung U ergibt sich damit aus einer Überlagerung eines periodischen Spannungssignals der Spannungsgrundfrequenz Uo und verschiedenen Spannungssignalen der Spannungsoberfrequenzen $U_1,...,U_n$ und des Spannungsgleichanteils $SDU_{n+1}$.

Mittels der Spektralanalyse gemäß dem Spektralanalyseschritt 201 lassen sich die einzelnen periodischen Spannungssignale nach Frequenzen separieren.

Dies ist für die Spannungsgrundfrequenz Uo, die erste Spannungsoberfrequenz $U_1$ und die zweite Spannungsoberfrequenz $U_2$ mit den drei Sinus-Funktionen unterschiedlicher Frequenz dargestellt. Die hier dargestellten Sinus-Funktionen sind lediglich illustrativer Natur und beschreiben keine realen Grund- und Oberschwingungen einer Versorgungsspannung U.

In Diagramm b), in dem Spannungsspektralwerte $SDU_0,...,SDU_n$ für die Grundfrequenz Uo und Oberfrequenzen $U_1,...,U_n$ der Versorgungspannung U gegen die Frequenz f aufgetragen sind, ist das entsprechende Spannungsfrequenzspektrum SDU der in Diagramm a) dargestellten Spannungsverlauf TCU der Versorgungsspannung U dargestellt.

Die einzelnen Bestandteile zur Versorgungspannung U sind in Diagramm b) anteilsmäßig nach ihrer jeweiligen Frequenz aufgetragen. Die drei in Diagramm b) als Peaks dargestellten Spannungsspektralwerte SDUo, $SDU_1$, $SDU_2$ entsprechen den drei Sinus-Funktionen mit der Spannungsgrundfrequenz Uo und den Spannungsoberfrequenzen $U_1$, $U_2$. Die Höhe der jeweiligen Peaks stellt zahlenmäßig den Anteil dar, den die jeweiligen Grund- und Oberwellen in dem in Diagramm a) dargestellten Spannungsverlauf TCU ausmachen. In Bezug auf die drei dargestellten Sinus-Funktionen entsprechen die Höhen der Peaks, sprich die Zahlenwerte der Spannungsspektralwerte SDUo, $SDU_1$, $SDU_2$, den Amplituden der entsprechenden Sinus-Funktionen.

Der Spannungsgleichanteil $SDU_{n+1}$ entspricht diesbezüglich einem konstanten Offset der Versorgungsspannung U gegenüber der Y-Achse.

Bei der Reduktion des Spannungsfrequenzspektrums SDU der Versorgungsspannung U auf die Spannungsgrundfrequenz Uo und die Spannungsoberfrequenzen $U_1,...,U_n$ gemäß dem Reduktionsschritt 205 werden aus einem Spannungsfrequenzspektrum SDU, vergleichbar zu dem in Diagramm b), nur die Spannungsspektralwerte $SDU_0,SDU_1,...,SDU_n$ der Spannungsgrund- und Spannungsoberfrequenzen $U_0,U_1,...,U_n$ berücksichtigt.

Bei der Identifikation der Spannungsspektralwerte $SDU_0,SDU_1,...,SDU_n$ der Spannungsgrundfrequenz Uo und der Spannungsoberfrequenzen $U_1,...,U_n$ als Spannungskenngrößen AFPU gemäß dem Spektralwertidentifikationsschritt 207 umfassen die Spannungskenngrößen AFPU n+1 Zahlenpaare bestehend aus einem Frequenzwert der jeweiligen Spannungsgrundfrequenz Uo oder Spannungsoberfrequenz $U_1,...,U_n$ und einem Zahlenwert, der den Anteil der entsprechenden Frequenz an dem Spannungsverlauf TCU der Versorgungsspannung U aufweist, sprich dem jeweiligen Spannungsspektralwert $SDU_0,SDU_1,...,SDU_n$. Ferner können die Spannungskenngrößen AFPU wenigstens einen zusätzlichen Wert für den Spannungsgleichanteil $SDU_{n+1}$ umfassen.

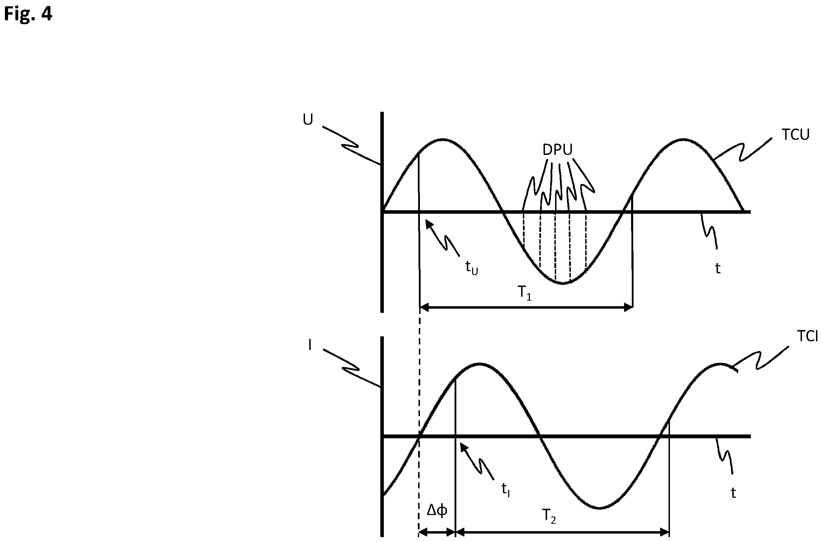

Fig. 4 zeigt eine schematische Abbildung einer Versorgungsspannung U und eines Verbraucherstroms I des Verfahrens 100 zur verteilten elektrischen Leistungsbestimmung gemäß einer weiteren Ausführungsform.

Dargestellt sind ein Spannungs-Zeit-Diagramm, in dem ein zeitlicher Spannungsverlauf TCU einer Versorgungsspannung U dargestellt ist, und ein Strom-Zeit-Diagramm, in dem ein zeitlicher Stromverlauf TCI eines Verbraucherstroms I dargestellt ist.

Sowohl die Versorgungsspannung U als auch der Verbraucherstrom I sind zur Vereinfachung der Illustration als reine Sinusspannung und reiner Sinusstrom dargestellt. In der Realität können natürlich sowohl die Versorgungsspannung U als auch der Verbraucherstrom I deutlich von einer reinen Sinusspannung oder einem reinen Sinusstrom abweichen.

Weiter ist im Spannungs-Zeit-Diagramm ein erstes Zeitintervall $T_1$ mit einem ersten Startzeitpunkt tu gekennzeichnet. Dieses erste Zeitintervall $T_1$ kennzeichnet die Zeitspanne, über die im Spannungsmessschritt 101 von der Spannungsmesseinrichtung 607 Spannungsmesswerte DPU der Versorgungsspannung U aufgenommen werden. Diese Spannungsmesswerte DPU sind im Spannungs-Zeit-Diagramm beispielhaft durch fünf Spannungsmesswerte DPU dargestellt. Es können aber über das ganze erste Zeitintervall $T_1$ eine hohe Anzahl von Spannungsmesswerten DPU aufgenommen werden.

Das Strom-Zeit-Diagramm weist ein analoges zweites Zeitintervall $T_2$ mit einem zweiten Startzeitpunkt $t_I$ auf, das die Zeitspanne beschreibt, über die im Strommessschritt 103 von der Strommesseinrichtung 609 Strommesswerte DPI des Verbraucherstroms I aufgenommen werden. Aus Gründen der Übersichtlichkeit sind in dem Strom-Zeit-Diagramm keine Strommesswerte DPI dargestellt.

Das erste Zeitintervall $T_1$ und das zweite Zeitintervall $T_2$ sind gleichlang und beschreiben damit eine identische Zeitspanne, in der Spannungsesswerte DPU und Strommesswerte DPI aufgenommen werden.

Das erste Zeitintervall $T_1$ und das zweite Zeitintervall $T_2$ sind jedoch zeitlich zueinander verschoben und weisen unterschiedliche Startzeitpunkte tu, $t_I$ auf.

Über die Synchronisation gemäß dem Synchronisationsschritt 209 kann durch einen Abgleich der ersten und zweiten Startzeitpunkten tu, $t_I$ der ersten und zweiten Zeitintervalle $T_1$, $T_2$ zu der globalen Referenzzeit eine Phasenverschiebung $\Delta\Phi$ der Versorgungsspannung U und des Verbraucherstroms I bestimmt werden. Mittels dieser Phasenverschiebung $\Delta\Phi$ zur Synchronisation gemäß dem Synchronisationsschritt 209 kann eine entsprechende Korrektur der aufgenommenen Spannungsmesswerte DPU oder Stromesswerte DPI durchgeführt werden.

Für den Fall, dass beispielsweise die lokale Uhr der Spannungsmesseinrichtung 607 als globale Referenzuhr dient, kann der erste Startzeitpunkt tu als ein Zeitstempel 915 dienen. Indem dieser Zeitstempel 915 von der Spannungsmesseinrichtung 607 an die Strommesseinrichtung 609 übermittelt wird, kann ein Abgleich des ersten Startzeitpunkts tu mit den jeweiligen zweiten Startzeitpunkten $t_I$ der Strommesseinrichtungen 609 zur Synchronisation der Spannungsmesseinrichtung 607 und der Strommesseinrichtungen 609 führen, indem die lokalen Uhren der Strommesseinrichtungen 609 zur Referenzuhr der Spannungsmesseinrichtung 607 in Relation gesetzt wird.

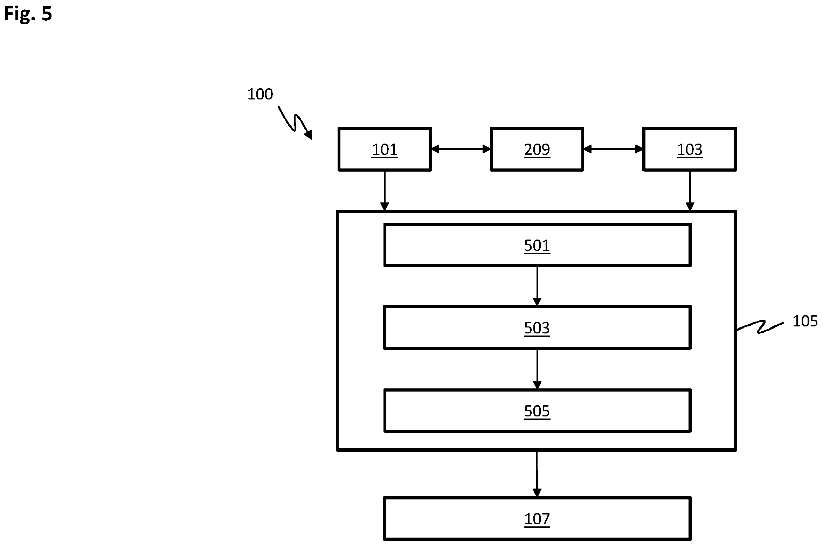

Fig. 5 zeigt ein Ablaufdiagramm des Verfahrens 100 zur verteilten elektrischen Leistungsbestimmung gemäß einer weiteren Ausführungsform.

Sofern nicht anderslautend beschrieben, umfasst das Verfahren 100 in Fig. 5 die unter Fig. 1 und Fig. 2 beschriebenen Schritte.

Gemäß Fig. 5 wird die Analyse der Spannungsmesswerte DPU und/oder der Strommesswerte DPI gemäß dem Analyseschritt 105 dadurch realisiert, dass gemäß einem Anpassungsschritt 501 ein Anpassungsprozess einer Anpassungsfunktion an die zu analysierenden Spannungsmesswerte DPU und/oder Strommesswerte DPI durchgeführt wird.

Ein Anpassungsprozess kann ein Prozess sein, in dem durch Variation entsprechender Parameter einer mathematischen Anpassungsfunktion diese an die zu analysierenden Spannungsmesswerte DPU und/oder Strommesswerte DPI angepasst wird, sodass nach erfolgreicher Anpassung die Anpassungsfunktion die Spannungsmesswerte DPU und/oder die Strommesswerte DPI wiedergibt und die jeweiligen Spannungsverläufe TCU oder Stromverläufe TCI beschreibt.

Bei der Anpassung wird für die Spannungsmesswerte DPU und die Strommesswerte DPI jeweils die gleiche Anpassungsfunktion verwendet. Auch werden zur Anpassung an die Spannungsmesswerte DPU und die Strommesswerte DPI die gleichen Parameter variiert.

Die Anpassung der Anpassungsfunktion an die Spannungsmesswerte DPU ergibt gemäß einem Parameterermittlungsschritt 503 damit Spannungsparameter PU während die Anpassung der Anpassungsfunktion an die Strommesswerte DPI Stromparameter PI ergibt.

Die Spannungsparameter PU und die Stromparameter PI beschreiben hierbei die tatsächlichen Zahlenwerte, die für die jeweiligen Parameter der Anpassungsfunktion durch den Anpassungsprozess der Anpassungsfunktion an die Spannungsmesswerte DPU oder die Strommesswerte DPI erhalten werden. Die Spannungsparameter PU und die Stromparameter PI sind daher lediglich unterschiedliche Zahlenwerte desselben Parameters, und dadurch charakterisiert, dass sie durch die Anpassungsprozesse der Anpassungsfunktion an die Spannungsmesswerte DPU und die Strommesswerte DPI erhalten werden.

Die Art der Parameter, die zur Anpassung der Anpassungsfunktion an die Spannungsmesswerte DPU oder die Strommesswerte DPI ausgewählt und variiert werden sind von der gewählten Anpassungsunktion abhängig. Die Wahl der geeigneten Anpassungsfunktion kann wiederum vom Spannungsverlauf TCU der Versorgungspannung U und/oder vom Stromverlauf TCI des Verbraucherstroms I der Spannungsmesswerte DPU und/oder Strommesswerte DPI abhängen.

Bei erfolgreicher Anpassung der Anpassungsfunktion an die Spannungsmesswerte DPU und/oder die Strommesswerte DPI werden in einem Parameteridentifikationsschritt 505 die Spannungsparameter PU als Spannungskenngrößen AFPU und/oder die Stromparameter PI als Stromkenngrößen AFPI identifiziert.

In dem darauffolgenden Leistungswertermittlungsschritt 107 wird unter Berücksichtigung der Spannungskenngrößen AFPU und/oder Stromkenngrößen AFPI zumindest ein Leistungswert L ermittelt.

Sind im Analyseschritt 105 Spannungsmesswerte DPU oder Strommesswerte DPI nicht analysiert worden, sieht die Ermittlung des zumindest einen Leistungswerts L gemäß dem Leistungswertermittlungsschritt 107 eine weitere Analyse dieser bis dahin nichtanalysierten Spannungsmesswerte DPU oder Strommesswerte DPI mittels des Anpassungsprozesses vor.

Nach erfolgreicher Bestimmung der Spannungskenngrößen AFPU oder Stromkenngrößen AFPI durch die Analyse der bis dahin nichtanalysierten Spannungsmesswerte DPU oder Strommesswerte DPI kann der zumindest eine Leistungswert L auf Basis der Spannungskenngrößen AFPU und der Stromkenngrößen AFPI ermittelt werden.

Alternativ können auch die im Analyseschritt 105 mittels des Anpassungsprozesses der Anpassungsfunktion an die Spannungsmesswerte DPU und/oder Strommesswerte DPI bestimmten Spannungskenngrößen AFPU oder Stromkenngrößen AFPI in die entsprechenden Spannungsmesswerte DPU und/oder Strommesswerte DPI rücktransformiert werden.

Eine derartige Rücktransformation kann beispielsweise dadurch erzielt werden, dass in die angepasste Anpassungsfunktion, in die die Spannungsparameter PU oder Stromparameter PI eingesetzt sind und die folglich den Spannungsverlauf TCU der Versorgungsspannung U oder den Stromverlauf TCI des Verbraucherstroms I der Spannungsmesswerte DPU oder der Strommesswerte DPI beschreibt, den jeweiligen Messwerten entsprechende Zeitwerte eingesetzt werden, um so die entsprechenden Spannungsmesswerte DPU oder Strommesswerte DPI zu erzielen.

Sind im Analyseschritt 105 Spannungsmesswerte DPU oder Strommesswerte DPI nicht analysiert und keine entsprechenden Spannungskenngrößen AFPU oder Stromkenngrößen AFPU bestimmt worden, bleiben diese Spannungsmesswerte DPU oder Strommesswerte DPI im Folgenden unverändert.

Eine Leistungsbestimmung des zumindest einen Leistungswerts L ist dann unter Berücksichtigung der so erhaltenen Spannungsmesswerte DPU und Strommesswerte DPI, beispielsweise durch eine Multiplikation einzelner Spannungsmesswerte DPU und Strommesswerte DPI, ermöglicht.

Fig. 6 zeigt eine schematische Abbildung eines Systems 600 zur verteilten elektrischen Leistungsbestimmung gemäß einer Ausführungsform.

Gemäß Fig. 6 umfasst das System 600 zur verteilten elektrischen Leistungsbestimmung eine Spannungsquelle 601 zum Bereitstellen einer Versorgungsspannung U, zumindest einen Verbraucher 605, der über einen Spannungspfad 603 mit der Spannungsquelle 601 verbunden ist, eine Spannungsmesseinrichtung 607 zur Messung der Versorgungsspannung U an einem Spannungsmesspunkt 613 auf dem Spannungspfad 603, zumindest eine Strommesseinrichtungen 609 zur Messung eines Versorgungsstroms I des Verbrauchers 605 an einem Strommesspunkt 615 auf dem Spannungspfad 603, eine Prozessoreinheit 611 zum Ermitteln zumindest eines Leistungswerts L und eine Steuerungseinheit 617 zum Ansteuern der Spannungsmesseinrichtung 607 und der zumindest einen Strommesseinrichtung 609.

Die Spannungsmesseinrichtung 607 ist ausgebildet, Spannungsmesswerte DPU der Versorgungsspannung U aufzunehmen, um einen Spannungsverlauf TCU der Versorgungsspannung U zu bestimmen, und die Spannungsmesswerte DPU mit einer Analysefunktion AF zu analysieren, um Spannungskenngrößen AFPU des Spannungsverlaufs TCU der Spannungsmesswerte DPU zu bestimmen.

Ferner ist die Spannungsmesseinrichtung 607 ausgebildet, ein erstes Datenpaket DP1 zu erstellen, das die Spannungskenngrößen AFPU umfasst, und das erste Datenpaket DP1 an die zumindest eine Prozessoreinheit 611 zu übermitteln.

Die zumindest eine Strommesseinrichtung 609 ist ausgebildet, Strommesswerte DPI der Verbraucherstroms I aufzunehmen, um einen Stromverlauf TCI des Verbraucherstroms I zu bestimmen, und die Strommesswerte DPI mit der Analysefunktion AF zu analysieren, um Stromkenngrößen AFPI des Stromverlaufs TCI der Strommesswerte DPI zu bestimmen.

Darüber hinaus ist die Strommesseinrichtung 609 ausgebildet, ein zweites Datenpaket DP2 zu erstellen, das die Stromkenngrößen AFPI umfasst, und das zweite Datenpaket DP2 an die zumindest eine Prozessoreinheit 611 zu übermitteln.

Die zumindest eine Prozessoreinheit 611 ist ausgebildet, zumindest einen Leistungswert L unter Berücksichtigung der Spannungskenngrößen AFPU und/oder der Stromkenngrößen AFPI zu ermitteln.

Das System 600 weist ferner eine Steuerungseinheit 617 auf, mittels der die Spannungsmesseinrichtung 607 und die Strommesseinrichtungen 609 angesteuert beziehungsweise mittels der eine verteilte Leistungsbestimmung initialisiert werden kann. Die Steuerungseinheit 617 kann als eine interne im System integrierte Steuerungseinheit 617 oder als eine externe Steuerungseinheit 617 ausgebildet sein.

Die Steuerungseinheit 617, die Spannungsmesseinrichtung 607 und die Strommesseinrichtungen 609 können miteinander über eine Kommunikationsverbindung 619 verbunden sein. Die Kommunikationsverbindung 619 kann ein Datenbus sein, der wiederum beispielsweise durch ein Feldbussystem realisiert sein kann. Die Kommunikation zwischen der Steuerungseinrichtung 607 und der Spannungsmesseinrichtung 607 und den Strommesseinrichtungen 609 kann über eine Datenkommunikation über den Datenbus erfolgen, beispielsweise über den Austausch entsprechender Datenpakete. Die Datenpakete können hierbei die Anforderungen bestimmter Busprotokolle erfüllen und beispielsweise als Ethernet-Protokolle oder EtherCAT-Protokolle ausgebildet sein.

In Fig. 6 umfasst das System 600 drei Verbraucher 605, die jeweils über den Spannungspfad 603 mit der Spannungsquelle 601 verbunden sind. Jeder der Verbraucher 605 weist eine Strommesseinrichtung 609 auf, die in Reihe zu dem jeweiligen Verbraucher 605 geschaltet ist, um den Verbraucherstrom I des jeweiligen Verbrauchers 605 zu bestimmen. Eine höhere oder niedrigere Anzahl von Verbrauchern 605 wäre aber ebenfalls denkbar.

In Fig. 6 liefert die Spannungsquelle 601 eine dreiphasige Wechselspannung. Die Erfindung soll jedoch nicht hierauf beschränkt sein.

In der Ausführungsform in Fig. 6 weist jede der Strommesseinrichtungen 609 einen Prozessor 611 auf, der in der jeweiligen Strommesseinrichtung 609 ausgebildet ist.

Es ist jedoch auch denkbar, den Prozessor 611 in der Spannungsmesseinrichtung 607 anzuordnen oder als einen externen Prozessor 611 auszubilden.

Die eine Spannungsmesseinrichtung 607 und die drei Strommesseinrichtungen 609 sind über eine Kommunikationsverbindung 619 miteinander verbunden, über die die Spannungsmesseinrichtung 607 in der Lage ist, ein erstes Datenpaket DP1 mit Spannungskenngrößen DPU aus einer Analyse der Spannungsmesswerte DPU der Versorgungsspannung U an die einzelnen Strommesseinrichtungen 609 zu übermitteln.

Dieses erste Datenpaket DP1 kann beispielweise in ein Busprotokoll eines Bussystems eingebunden sein. Beispielsweise kann ein solches Busprotokoll durch ein Ethernet-Telegramm ET beziehungsweise durch ein EtherCAT-Telegramm realisiert sein.

Zu einer verteilten Leistungsbestimmung von zumindest einem Leistungswert L nimmt die Spannungsmesseinrichtung 607 an einem Spannungsmesspunkt 613 Spannungsmesswerte DPU der Versorgungsspannung U gemäß dem Spannungsmessschritt 101 des Verfahrens 100 zur verteilten Leistungsbestimmung auf.

Die Strommesseinrichtungen 609 nehmen gemäß dem Strommessschritt 103 an Strommesspunkten 615 Strommesswerte DPI des Verbraucherstroms I auf.

Die Spannungsmesspunkte 613 und die Strommesspunkte 615 sind räumlich an verschiedenen Stellen im System 600 angeordnet.

Darauffolgend analysiert die Spannungsmesseinrichtung 607 die Spannungsmesswerte DPU mit einer Analysefunktion AF und erstellt Spannungskenngrößen AFPU gemäß dem Analyseschritt 105 des Verfahrens 100.

Beispielsweise kann die Spannungsmesseinrichtung 607 zur Analyse der Spannungsmesswerte DPU im Analyseschritt 105 eine Spektralanalyse gemäß dem Spektralanalyseschritt 201, dem Spektrumerstellungsschritt 203, dem Reduktionsschritt 205 und dem Spektralwertidentifikationsschritt 207 durchführen.

Alternativ kann die Spannungsmesseinrichtung 607 auch eine Analyse der Spannungsmesswerte DPU mit einer Anpassungsfunktion gemäß dem Anpassungsschritt 501, dem Parameterermittlungsschritt 503 und dem Parameteridentifikationsschritt 505 durchführen.

Darauffolgend erstellt die Spannungsmesseinrichtung 607 ein erstes Datenpaket DP1 mit den Spannungskenngrößen AFPU und übermittelt dieses über die Kommunikationsverbindung 619 an die Strommesseinrichtungen 609.

Die Strommesseinrichtungen 609 nehmen im Strommessschritt 103 Strommesswerte DPI auf und können bereits im Analyseschritt 105 diese, beispielsweise mittels der Spektralanalyse gemäß dem Spektralanalyseschritt 201, dem Spektrumerstellungsschritt 203, dem Reduktionsschritt 205 und dem Spektralwertidentifikationsschritt 207, analysieren und die Stromkenngrößen AFPI bestimmen.

Alternativ können die Strommesseinrichtungen 609, beziehungsweise die hierin ausgebildeten Prozessoreinheiten 611, auch erst in einem Leistungswertermittlungsschritt 107 die Strommesswerte DPI analysieren und Stromkenngrößen AFPI bestimmen, um auf Basis der Spannungskenngrößen AFPU und der Stromkenngrößen AFPI den zumindest einen Leistungswert L zu ermitteln.

Ebenfalls möglich ist eine Rücktransformation der im ersten Datenpaket DP1 an die Strommesseinrichtungen 609 übermittelten Spannungskenngrößen AFPU in die Spannungsmesswerte DPU durch die Strommesseinrichtungen 609, beziehungsweise durch die darin ausgebildeten Prozessoreinheiten 611, um auf Basis der Spannungsmesswerte DPU und Strommesswerte DPI den zumindest einen Leistungswert L zu ermitteln.

Zur Synchronisation der Spannungsmesseinrichtung 607 und der Strommesseinrichtungen 609 weisen die Spannungsmesseinrichtung 607 und die Strommesseinrichtungen 609 jeweils eine individuelle lokale Zeitbestimmung (nicht dargestellt) auf. Beispielsweise können die Spannungseinrichtung 607 und die Strommesseinrichtungen 609 mit jeweils einer lokalen Uhr ausgebildet sein.

Die Synchronisation kann gemäß dem Synchronisationsschritt 209 mittels eines Abgleichs der internen lokalen Uhren der Spannungseinrichtung 607 und der Strommesseinrichtungen 609 mit einer globalen Zeitbestimmung, beispielsweise einer globalen Referenzuhr des Systems 600, erzielt werden.

Beispielsweise kann auch eine der lokalen Uhren der Spannungsmesseinrichtung 607 und der Strommesseinrichtungen 609 als globale Referenzuhr dienen. Hierbei können die lokalen Uhren, die nicht als globale Referenzuhr dienen, mit der globalen Referenzuhr abgeglichen werden, indem die jeweilige Spannungsmesseinrichtung 607 oder die Strommesseinrichtung 609, die mit der globalen Referenzuhr ausgebildet ist, entsprechende Zeitbestimmungen an die jeweils anderen Spannungsmesseinrichtungen 607 oder Strommesseinrichtungen 609 sendet, mittels denen die lokalen Uhren der Spannungsmesseinrichtung 607 oder der Strommesseinrichtungen 609 abgeglichen werden können.

Für das in Fig. 6 gezeigte System 600, bei dem die Spannungsmesseinrichtung 607 vor den Strommesseinrichtungen 609 angeordnet ist, kann die lokale Uhr der Spannungsmesseinrichtung 607 als globale Referenzuhr ausgebildet sein.

Zur Synchronisation kann von der Spannungsmesseinrichtung 607 eine Referenzuhrzeit der globalen Referenzuhr an die Strommesseinrichtungen 609 mittels eines ersten Datenpakets DP1 übermittelt werden, sodass die lokalen Uhren der Strommesseinrichtungen 609 zur Referenzuhrzeit der Referenzuhr in Relation gesetzt werden können.

Die Datenübertragung der ersten Datenpakete DP1 und/oder zweiten Datenpakete DP2 zwischen der Spannungsmesseinrichtung 607 und/oder der Strommesseinrichtungen 609, beziehungsweise den in diesen ausgebildeten Prozessoreinheiten 611, kann mittels der Kommunikationsverbindung 619 realisiert sein, die in Fig. 6 zwischen der Spannungsmesseinrichtung 607 und den Strommesseinrichtungen 609 ausgebildet ist.

Wie bereits oben erwähnt können die Steuerungseinheit 617, die Spannungsmesseinrichtung 607 und die Strommesseinrichtungen 609 in ein Feldbussystem, beispielsweise in ein Ethernet-Netzwerk, eingebunden sein.

Bei Ethernet-Netzwerken sind die Mehrzahl von Teilnehmern, auch Knoten genannt, über ein gemeinsames Übertragungsmedium miteinander verbunden, wobei eine Verkapselung der zu übermittelnden Daten in sogenannten Ethernet-Datenpaketen, im Weiteren auch als Ethernet-Telegramme bezeichnet, mit einem vorgegebenen Format vorgenommen wird.

Das Ethernet besteht aus drei Bereichen, dem Übertragungsmedium und den Netzwerk-Schnittstellen, d. h. der Hardware, der Menge von Protokollen, die den Zugriff auf das Übertragungsmedium steuern, und der Ethernet-Paketform. Das Ethernet stellt dabei grundsätzlich ein Busnetz dar, wobei beliebige Netzwerktopologien, z.B. Stern-, Bus- oder Baumnetze verwendet werden können.

Die Ethernet-Datenübertragung findet üblicherweise mithilfe des CSMA/CD-Zugriffsverfahrens statt, bei dem eine Datenübertragung nur durchgeführt wird, wenn das Netz ruhig ist, sprich zu diesem Zeitpunkt keine weiteren Daten übertragen werden. Darüber hinaus ist ein Kollisionsverhinderungsmechanismus vorgesehen.

Das Ethernet-Datenpaket selbst kann dabei eine Datenlänge von bis zu 1500 Bytes aufweisen, wobei die Daten mittels Header und Trailer, die eine Anfangskennung, die Ziel- und Quelladresse, den Datenpakettyp und den Fehlererkennungsmechanismus angeben, verkapselt sind.

Das Ethernet hat sich als Kommunikationsstandard für Netzwerksysteme vor allem in der Bürokommunikation durchgesetzt, da Standard-Hardware-Komponenten und -Software-Protokolle genutzt werden können und darüber hinaus hohe Datenübertragungsraten möglich sind. Aus diesem Grund ist es auch wünschenswert, den Ethernet-Standard in industrieller Umgebung bei der Datenübertragung, insbesondere von Steuerungsaufgaben nutzen zu können.

Das wesentliche Problem besteht hierbei in der mangelnden Echtzeitfähigkeit des Ethernet-Standards, so dass Automatisierungsaufgaben mit Echtzeitanwendungen in der Regel von Ethernet-Kommunikationsnetzen getrennt in eigenständigen Steuerungsbaugruppen, sogenannten Feldbussystemen, durchgeführt werden.

Um den Ethernet-Standard und ein entsprechend ausgelegtes Netzwerk auf einfache und kostengünstige Weise auch zur Ausführung von Automatisierungsaufgaben, insbesondere solche, bei denen die einzelnen, an der Steuerung beteiligten Teilnehmer, Prozessdaten von nur wenigen Bytes benötigen, verwenden zu können, kann ein Netzwerkaufbau realisiert werden, bei dem ein zusätzlicher Netzwerk-Koppler, im weiteren auch Ethernet-Koppler bezeichnet, vorgesehen ist, der eine externe Schnittstelle zur Anbindung an ein Ethernet-Netzwerk aufweist.

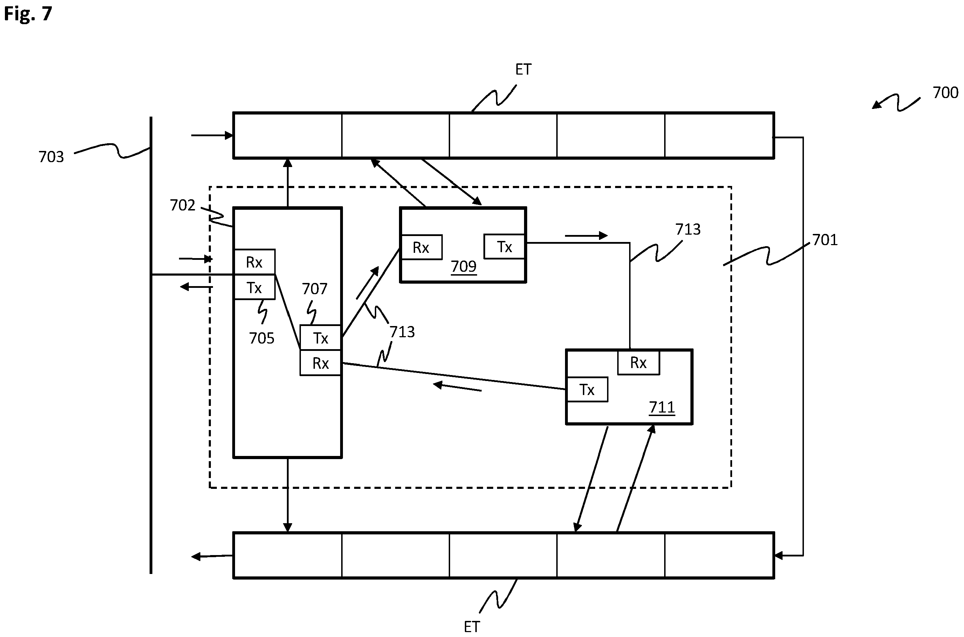

Fig. 7 zeigt eine schematische Abbildung eines Ethernet-Netzwerkaufbaus 700 mit einem Ethernet-Klemmensystem 701, das an einen externen Datenbus 703 eines Ethernet-Netzwerks angeschlossen ist.

Das Ethernet-Klemmensystem 701 umfasst einem Ethernet-Koppler 702 und eine Spannungsmesseinrichtungsklemme 709 und zumindest eine Strommesseinrichtungsklemme 711. Der Ethernet-Koppler 702 und die jeweiligen Spannungs- und Strommesseinrichtungsklemmen 709, 711 sind mechanisch und elektrisch miteinander verbunden. Selbstverständlich können zwischen dem Ethernet-Koppler 702, der Spannungsmesseinrichtungsklemme 709 und/oder der Strommesseinrichtungsklemme 711 weitere elektronische Klemmen in das Ethernet-Klemmensystem 701 eingebunden sein.

Die Spannungsmesseinrichtungsklemme 709 und die Strommesseinrichtungsklemmen 711 sind als Ethernet-Klemmen ausgebildet und dienen jeweils dazu, die Spannungsmesseinrichtung 607 (in Fig. 7 nicht dargestellt) und die Strommesseinrichtung 609 (in Fig. 7 nicht dargestellt) in das Ethernet-Netzwerk, insbesondere den externen Datenbus 703 einzubinden.

Der Ethernet-Koppler 702, die Spannungsmesseinrichtungsklemme 709 und die Strommesseinrichtungsklemme 711 sind untereinander über einen internen Datenbus 713 verbunden, der zur Datenkommunikation dient.

Mittels des Ethernet-Kopplers 702 ist das Ethernet-Klemmensystem 701 an den externen Datenbus 703 angeschlossen. Über den externen Datenbus 703 sind die jeweils mit der Spannungsmesseinrichtungsklemme 709 und der Strommesseinrichtungsklemme 711 verbundene Spannungsmesseinrichtung 607 und Strommesseinrichtung 609 über die Steuerungseinheit 617 ansteuerbar. Die Steuerungseinheit 617 (in Fig. 7 nicht dargestellt) ist mit dem externen Datenbus 703 verbunden. In Fig. 7 ist die Kommunikationsverbindung 619 des Systems 600 in Fig. 6 durch den externen Datenbus 703 und den internen Datenbus 713 realisiert.

Zur Steuerung der Spannungsmesseinrichtung 607 und der Strommesseinrichtung 609 durch die Steuerungseinheit 617 kann die Steuerungseinheit 617 Ethernet-Telegramme ET an die Spannungsmesseinrichtungsklemme 709 und die Strommesseinrichtungsklemme 711 aussenden, in denen die entsprechenden Anweisungen der Steuerungseinheit 617 an die Spannungsmesseinrichtung 607 und der Strommesseinrichtung 609 enthalten sind.

Der Ethernet-Koppler 702 weist eine externe Schnittstelle 705 und eine interne Schnittstelle 707 zur Anbindung des Ethernet-Klemmensystems 701 an den externen Datenbus 703 auf und dient dazu, den externen Datenbus 703 und den internen Datenbus 713, der zur Datenkommunikation innerhalb des Ethernet-Klemmensystems 701 dient, miteinander zu verbinden und eine Datenübertragung zwischen beiden Systemen zu realisieren.

In der in Fig. 7 gezeigten Ausführungsform ist der Ethernet-Koppler 702 mit der externen Schnittstelle 705 direkt an den externen Datenbus 703 angeschlossen, der als Übertragungsmedium beispielsweise ein Koaxialkabel, ein Twisted-Pair-Kabel oder ein Glasfaserkabel aufweisen kann.

Die externe Schnittstelle 705 und die interne Schnittstelle 707 weisen jeweils eine Empfangseinheit RX und eine Sendeeinheit TX auf, mittels denen Ethernet-Telegramme ET empfangen und gesendet werden können.

Mittels der Empfangseinheit RX der externen Schnittstelle 705 empfängt der Ethernet-Koppler 702 ein von der Steuerungseinheit 617 über den externen Datenbus 703 ausgesendetes Ethernet-Telegramm ET und sendet dieses Ethernet-Telegramm ET mittels der Sendeeinheit TX der internen Schnittstelle 707 über den internen Datenbus 713 an die Spannungsmesseinrichtungsklemme 709 und die Strommesseinrichtungsklemme 711 des Klemmensystems 701.

Die Spannungsmesseinrichtungsklemme 709 und die Strommesseinrichtungsklemme 711 weisen jeweils ebenfalls eine Empfangseinheit RX auf, mit der Ethernet-Telegramme ET empfangen werden können, und eine Sendeeinheit TX auf, mit der Ethernet-Telegramme ET gesendet werden können.

Das vom Ethernet-Koppler 702 über den internen Datenbus 713 ausgesendete Ethernet-Telegramm ET (in der Fig. 7 als das obere Ethernet-Telegramm ET dargestellt) wird von der Spannungsmesseinrichtungsklemme 709 über die Empfangseinheit RX empfangen.

Die Spannungsmesseinrichtungsklemme 709 liest das empfangene Ethernet-Telegramm ET in dem für die Spannungsmesseinrichtungsklemme 709 bestimmten Abschnitt des Ethernet-Telegramms ET aus.

Beispielsweise entnimmt die Spannungsmesseinrichtungsklemme 709 aus den jeweils für sie bestimmten Anweisungen des Ethernet-Telegramms ET die Aufforderungen an die Spannungsmesseinrichtung 607, Spannungsmesswerte DPU aufzunehmen, zu analysieren und Spannungskenngrößen AFPU zu bestimmen und/oder die Spannungskenngrößen AFPU auszugeben.

Beispielsweise können diese Spannungskenngrößen AFPU bereits in erste Datenpakete DP1 in das Ethernet-Telegramm ET eingefügt werden.

Darauffolgend fügt die Spannungsmesseinrichtungsklemme 709 beispielsweise Spannungsmesswerte DPU oder Spannungskenngrößen AFPU der Spannungsmesseinrichtung 607 in den entsprechenden Abschnitt des Ethernet-Telegramms ET ein.

Das Auslesen und das Einfügen der Daten ist durch die Pfeile zwischen der Spannungsmesseinrichtungsklemme 709 und dem Ethernet-Telegramm ET dargestellt.

Darauffolgend sendet die Spannungsmesseinrichtungsklemme 709 das Ethernet-Telegramm ET mittels der Sendeeinheit TX über den internen Datenbus 713 an die Strommesseinrichtungsklemme 711.

Die Übertragungsrichtung ist durch die Pfeile entlang des internen Datenbusses 713 gekennzeichnet.

Die Strommesseinrichtungsklemme 711 empfängt das Ethernet-Telegramm ET durch die Empfangseinheit RX und liest dieses aus.

Die Strommesseinrichtungsklemme 711 entnimmt dem Ethernet-Telegramm ET wiederum dem für die Strommesseinrichtungsklemme 711 bestimmten Abschnitt die entsprechenden Anweisungen und fügt beispielsweise Strommesswerte DPI oder Stromkenngrößen AFPI der Strommesseinrichtung 609 in das Ethernet-Telegramm ET ein.

Das Auslesen und das Einfügen der Daten ist durch die Pfeile zwischen der Strommesseinrichtungsklemme 711 und dem Ethernet-Telegramm ET (in diesem Fall das untere Ethernet-Telegramm) dargestellt.

Darauffolgend sendet die Strommesseinrichtungsklemme 711 das Ethernet-Telegramm ET wieder an den Buskoppler 702, der das Ethernet-Telegramm ET über die externe Schnittstelle 705 und den externen Datenbus 703 an die Steuerung 617 zur Auswertung der jeweiligen Daten zurücksendet.

Das obere und das untere Ethernet-Telegramm ET stellen beide dasselbe Ethernet-Telegramm ET dar und sollen verdeutlichen, dass nach Abarbeitung der jeweiligen Anweisungen des Ethernet-Telegramms ET durch die Spannungs- und Strommesseinrichtungsklemmen 709, 711 das Ethernet-Telegramm ET wieder an den Buskoppler 702 zurückgesendet wird.

Das oben beschriebene Ethernet-Telegramm ET setzt sich aus einem Header mit der Empfangskennung und der Ziel- und Quelladresse, einem Datenbereich sowie einem Trailer, der eine Paketlänge und einen Fehlererkennungsmechanismus angibt, zusammen.

Der zwischen dem Header und dem Trailer vorgesehene Datenbereich enthält die für die Steuerungsaufgabe notwendigen Prozessdaten, die vorzugsweise ein gesamtes Prozessabbild wiedergeben. Diese Prozessdaten sind wiederum vorzugsweise in für die einzelnen Teilnehmer der Steuerungsaufgabe erforderlichen Datenblöcken für die Spannungsmesseinrichtungsklemme 709 beziehungsweise die Spannungsmesseinrichtung 607 und die Strommesseinrichtungsklemme 711 beziehungsweise die Strommesseinrichtungen 609 gruppiert.

Die Prozessdaten können Anweisungen an die jeweiligen Teilnehmer umfassen, bestimmte Prozessschritte durchzuführen. Beispielsweise können die Prozessdaten Anweisungen an die Spannungsmesseinrichtung 607 und/oder Strommesseinrichtungen 609 umfassen, Spannungsmesswerte DPU oder Strommesswerte DPI aufzunehmen oder diese zu analysieren und Spannungskenngrößen AFPU oder Stromkenngrößen AFPI zu erstellen, beziehungsweise zumindest einen Leistungswert L zu bestimmen.

Auch können die Prozessdaten bereits erstellte Spannungskenngrößen AFPU und/oder Stromkenngrößen AFPI zur Übermittlung zwischen der Spannungsmesseinrichtung 607 und den Strommesseinrichtung 609 umfassen.

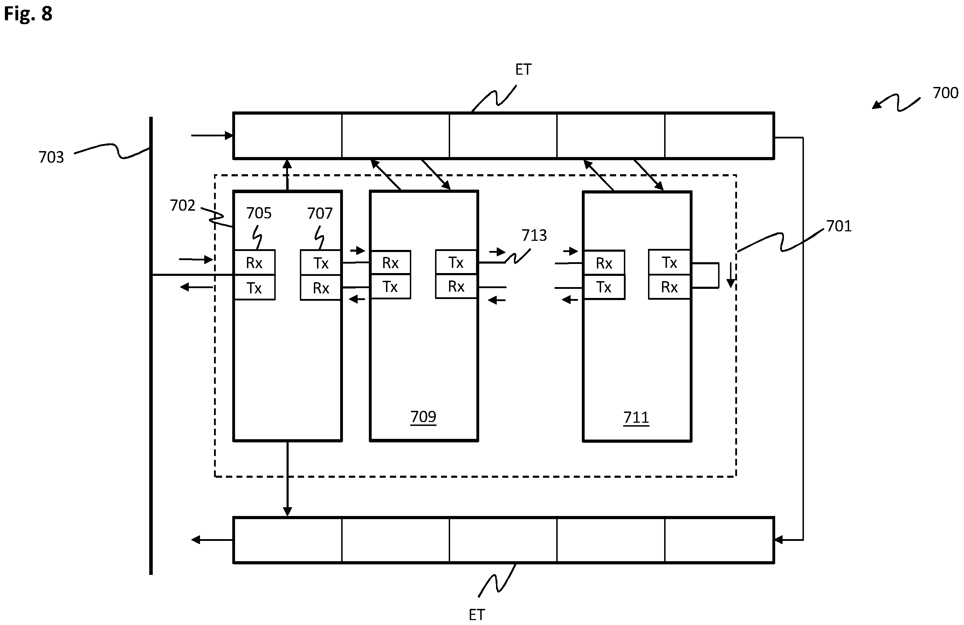

In Fig. 8 ist eine weitere Ausführungsform des Ethernet-Netzwerkaufbaus 700 in Fig. 7 gezeigt. In dieser Ausführungsform ist der Ethernet-Netzwerkaufbau 700 mit einer Zweikanal-Leitung dargestellt.

Im Unterschied zu Fig. 7 weisen in Fig. 8 die Spannungsmesseinrichtungsklemme 709 und die Strommesseinrichtungsklemme 711 jeweils zwei Empfangseinheiten RX und zwei Sendeeinheiten TX auf.

In Fig. 8 durchläuft das vom Ethernet-Koppler 702 an die Spannungsmesseinrichtungsklemme 709 gesendete Ethernet-Telegramm ET alle Klemmen des Ethernet-Klemmensystems 701 und wird von der letzten Strommesseinrichtungsklemme 711 des Klemmensystems 701 durch alle angeschlossenen Klemmen des Ethernet-Klemmensystems 701, also im dargestellten Fall zumindest durch die Spannungsmesseinrichtungsklemme 709 hindurch, an den Ethernet-Koppler 702 zurückgesendet.

Jedoch findet ein Auslesen des Ethernet-Telegramms ET und ein Einfügen von Daten in das Ethernet-Telegramm ET durch die Spannungsmesseinrichtungsklemme 709 und die Strommesseinrichtungsklemme 711 nur auf der Hinrichtung statt.

Das Auslesen und Einfügen ist durch die Pfeile zum oberen Ethernet-Telegramm ET und von diesem zu der Spannungsmesseinrichtungsklemme 709 und der Strommesseinrichtungsklemme 711 dargestellt.

Auf der Rückrichtung findet keine Abarbeitung des Ethernet-Telegramms ET statt, sondern das Ethernet-Telegramm ET wird nur weitergeleitet.

Sofern in dem Ethernet-Klemmensystem 701 ein Ethernet-Telegramm ET entsprechend dem EtherCAT-Standard verwendet wird und der Ethernet-Koppler 702, die Spannungsmesseinrichtungsklemme 709 und die Strommesseinrichtungsklemme 711 entsprechend dem EtherCAT-Standard ausgebildet sind, ist ein Austausch der Daten zwischen dem Ethernet-Telegramm ET und der Spannungsmesseinrichtungsklemme 709 und der Strommesseinrichtungsklemme 711 im Durchlauf möglich. Die Vorteile dieser Vorgehensweise sind, dass aufgrund der Verarbeitung des Ethernet-Telegramms ET im Durchlauf keine nennenswerten Verzögerungen bei der Datenverarbeitung entstehen und somit kurze Reaktionszeiten, wie sie für eine Echtzeitanwendung erforderlich sind, eingehalten werden können.

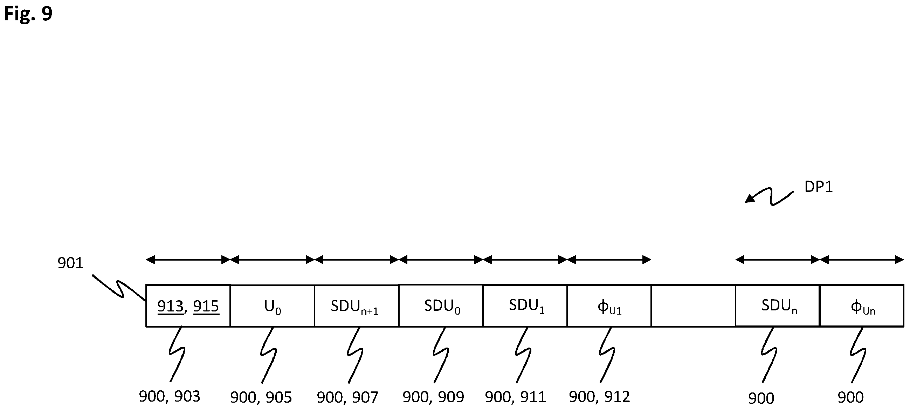

Fig. 9 zeigt eine schematische Abbildung eines ersten Datenpakets DP1 des Systems 600 zur verteilten elektrischen Leistungsbestimmung gemäß einer weiteren Ausführungsform.

Zur Übermittlung der in der Spannungsmesseinrichtung 607 und/oder den Strommesseinrichtungen 609 erstellten Spannungskenngrößen AFPU und/oder Stromkenngrößen AFPI können diese in erste Datenpakete DP1 und/oder zweite Datenpakete DP2 zusammengefasst werden.

Zur Übermittlung können die ersten Datenpakete DP1 und/oder zweiten Datenpakete DP2 beispielsweise in die oben beschriebenen Ethernet-Telegramme ET eingefügt werden.

In Fig. 9 ist ein durch die Spannungsmesseinrichtung 607 erstelltes erstes Datenpaket DP1 dargestellt. Ein durch die Strommesseinrichtung 607 erstelltes zweites Datenpaket DP2 kann eine analoge Datenstruktur wie das erste Datenpaket DP1 aufweisen, in dem die Stromkenngrößen AFPI analog zu den in Fig. 7 dargestellten Spannungskenngrößen AFPU angeordnet sein können. Um Wiederholungen zu vermeiden, wird im Folgenden im Wesentlichen der Aufbau des ersten Datenpakets DP1 beschrieben.

Gemäß Fig. 9 weist das erste Datenpaket DP1 einen Datenrahmen 901 auf, der eine Mehrzahl von Datenabschnitten 900 umfasst. Die einzelnen Datenabschnitte 900 des ersten Datenpakets DP1 umfassen verschiedene Betriebsdaten und weisen in der dargestellten Ausführungsform eine Größe von 4 Byte (jeweils mit einem Doppelpfeil gezeichnet) auf.

In Fig. 9 umfassen die Datenabschnitte 900 Spannungskenngrößen AFPU der Versorgungsspannung U, die in dem Analyseschritt 105 mittels einer Analyse von Spannungsmesswerten DPU erstellt worden sind.

In der Ausführungsform in Fig. 9 sind die Spannungskenngrößen AFPU mittels einer Spektralanalyse der Spannungsmesswerte DPU gemäß dem Spektralanalyseschritt 201, dem Spektrumerstellungsschritt 203, dem Reduktionsschritt 205 und dem Spektralwertidentifikationsschritt 207 analysiert. Die Spannungskenngrößen AFPU umfassen damit Informationen bezüglich der Spannungsgrund- und Spannungsoberfrequenzen $U_0, U_1,..., U_n$ und Spannungsspektralwerte $SDU_0, SDU_1,... , SDU_n$ der Spannungsgrundfrequenz Uo und der ersten n Spannungsoberfrequenzen $U_1,..., U_n$ sowie dem Spannungsgleichanteil $SDU_{n+1}$ der Versorgungspannung U.

Bei einer Analyse der Spannungsmesswerte DPU gemäß dem Analyseschritt 105, die nicht mittels einer Spektralanalyse gemäß dem Spektralanalyseschritt 201, dem Spektrumerstellungsschritt 203, dem Reduktionsschritt 205 und dem Spektralwertidentifikationsschritt analysiert wurden, kann die Aufteilung des ersten Datenpakets DP1 von der in Fig. 9 dargestellten Aufteilung abweichen.

Der erste Datenabschnitt 903 umfasst eine Kanalnummer 913 und einen Zeitstempel 915.

Die Kanalnummer 913 kennzeichnet die Phase der gegebenenfalls mehrphasigen Versorgungsspannung U, für die von der Spannungsmesseinrichtung 607 die Spannungsmesswerte DPU aufgenommen wurden.

Der Zeitstempel 915 kann beispielsweise der Startzeitpunkt tu des ersten Zeitintervalls T1 sein, das die Zeitspanne zur Aufnahme der Spannungsmesswerte DPU bestimmt. Der Zeitstempel 915 beziehungsweise der erste Startzeitpunkt tu dient zur Synchronisation der Spannungsmesseinrichtung 607 und der Strommesseinrichtungen 609 und wird daher innerhalb des ersten Datenpakets DP1 an die Prozessoreinheit 611 oder die Strommesseinrichtungen 609 übermittelt.

Mit der Kanalnummer 913 und dem Zeitstempel 915 ist die jeweilige Prozessoreinheit 611 in der Lage, die in dem ersten Datenpaket DP1 übermittelten Spannungskenngrößen AFPU auf entsprechende Strommesswerte DPI beziehungsweise Stromkenngrößen AFPI zu synchronisieren.

Der zweite Datenabschnitt 905 umfasst die Frequenzzahl der Spannungsgrundfrequenz Uo der Versorgungsspannung. Mit der Spannungsgrundfrequenz Uo lassen sich alle Spannungsoberfrequenzen $U_1,..., U_n$ der Versorgungsspannung U als ganzzahlige Vielfache der Spannungsgrundfrequenz Uo bestimmen.

Der dritte Datenabschnitt 907 umfasst den entsprechenden Spannungsgleichanteil $SDU_{n+1}$.

Der vierte Datenabschnitt 909 umfasst den Spannungsspektralwert SDUo der Spannungsgrundfrequenz Uo.

Der fünfte Datenabschnitt 911 umfasst den Spannungsspektralwert $SDU_1$ der ersten Spannungsoberfrequenz $U_1$.

Der sechste Datenabschnitt 912 umfasst einen Spannungsphasenwinkel $\phi_{U1}$ der ersten Oberschwingung in Bezug auf die Grundschwingung.

In den folgenden Abschnitten folgen paarweise die Spannungsspektralwerte $SDU_2,... , SDU_n$ und die jeweiligen Spannungsphasenwinkeln $\phi_{U2},..., \phi_{Un}$ der 2-ten bis n-ten Spannungsoberfrequenzen $U_2,..., U_n$.

Das derart gestaltete erste Datenpaket DP1 umfasst damit eine Anzahl von 4+2*(n-1) Abschnitten, wobei n die Anzahl der bestimmten Spannungsoberfrequenzen $U_1,..., U_n$ zur Spannungsgrundfrequenz Uo der Versorgungsspannung U ist. Da jeder Abschnitt eine Datentypgröße von 4 Bytes aufweist, weist der Datenrahmen 701 eine Gesamtdatengröße von $n_{BYTES}=(4+2*(n-1))*4$ auf.

Je nach Anzahl n der bestimmten Spannungsoberfrequenzen $U_1,..., U_n$ können die Anzahl der Anschnitte und die Größe des zu übermittelnden ersten Datenpakets DP1 variieren.

Ein erstes Datenpaket DP1 gemäß Fig. 9 weist einen vergleichbaren Informationsgehalt zu den entsprechenden Spannungsmesswerten DPU auf. Wie oben dargestellt können durch die Spannungsspektralwerte $SDU_0, SDU_1,..., SDU_n$, den Spannungsgleichanteil $SDU_{n+1}$ und die jeweiligen Spannungsphasenwinkeln $\phi_{U1},..., \phi_{Un}$ der Spannungsgrundfrequenz Uo und der ersten n Spannungsoberfrequenzen $U_1,..., U_n$ die Scheinleistung S, die Wirkleistung P, die Blindleistung Q oder die Verzerrungsblindleistung D bestimmt werden.

Durch eine entsprechende Rücktransformation können die Spannungsspektralwerte $SDU_0, SDU_1,..., SDU_n$ unter Berücksichtigung der jeweiligen Spannungsphasenwinkeln $\Phi_{U1},..., \Phi_{Un}$ der Spannungsgrundfrequenz Uo und der ersten n Spannungsoberfrequenzen $U_1,..., U_n$ und dem Spannungsgleichanteil $SDU_{n+1}$ in die Spannungsmesswerte DPU rücktransformiert werden.

Die Gesamtdatengröße des ersten Datenpakets DP1 ist jedoch wesentlich kleiner als ein die Spannungsmesswerte DPU umfassendes Datenpaket, das einen zum ersten Datenpaket DP1 vergleichbaren Informationsgehalt aufweist kann.

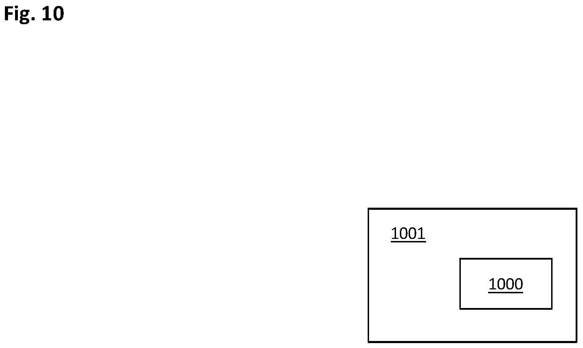

Fig. 10 zeigt eine schematische Abbildung eines Speichermediums 1001 mit einem Computerprogramm 1000 zur Ausführung des Verfahrens 100 zur Steuerung eines Automatisierungsprozesses.

Bezugszeichenliste

| | |
|---|---|
| 100 | Verfahren zur verteilten elektrischen Leistungsbestimmung |
| 101 | Spannungsmessschritt |
| 103 | Strommessschritt |
| 105 | Analyseschritt |

| | |
|---|---|
| 107 | Leistungswertermittlungsschritt |
| 201 | Spektralanalyseschritt |
| 203 | Spektrumerstellungsschritt |
| 205 | Reduktionsschritt |
| 207 | Spektralwertidentifikationsschritt |
| 209 | Synchronisationsschritt |
| U | Versorgungsspannung |
| I | Verbraucherstrom |
| DPU | Spannungsmesswert |
| DPI | Strommesswert |
| TCU | Spannungsverlauf |
| TCI | Stromverlauf |
| AF | Analysefunktion |
| AFPU | Spannungskenngröße |
| AFPI | Stromkenngröße |
| Uo | Spannungsgrundfrequenz |
| $U_1,...,U_n$ | erste n Spannungsoberfrequenzen |
| $\Phi_{U1},...,\Phi_{Un}$ | Spannungsphasenwinkel der ersten n Oberschwingungen zur Grundschwingungen der Spannungsversorgung |
| $I_0$ | Stromgrundfrequenz |
| $I_1,...,I_n$ | erste n Stromoberfrequenzen |
| $\Phi_{I1},...,\Phi_{In}$ | Stromphasenwinkel der ersten n Oberschwingungen zur Grundschwingungen dem Verbraucherstrom |
| SD | Frequenzspektrum |
| SDU | Spannungsfrequenzspektrum |
| SDUo | Spannungsspektralwert der Grundfrequenz der Versorgungsspannung |
| $SDU_1,...,SDU_n$ | Spannungsspektralwerte der ersten n Oberfrequenzen der Versorgungsspannung |
| $SDU_{n+1}$ | Spannungsgleichanteil |
| SDI | Stromfrequenzspektrum |
| $SDI_0$ | Stromspektralwert der Grundfrequenz des Verbraucherstroms |
| $SDI_1,...,SDI_n$ | Stromspektralwerte der ersten n Oberfrequenzen der Verbraucherstroms |
| $SDI_{n+1}$ | Stromgleichanteil |
| PU | Spannungsparameter |
| PI | Stromparameter |
| DP1 | erstes Datenpaket |
| DP2 | zweites Datenpaket |
| t | Zeit |
| f | Frequenz |
| $t_U$ | erster Startzeitpunkt |
| $t_I$ | zweiter Startzeitpunkt |
| T1 | erstes Zeitintervall |
| T2 | zweites Zeitintervall |
| $\Delta\Phi$ | Phasenverschiebung |
| 401 | Phasenverschiebungsermittlungsschritt |
| 501 | Anpassungsschritt |
| 503 | Spannungsparameterermittlungsschritt |
| 505 | Parameteridentifikationsschritt |
| 600 | System zur verteilten elektrischen Leistungsbestimmung |
| 601 | Spannungsquelle |
| 603 | Spannungspfad |
| 605 | Verbraucher |
| 607 | Spannungsmesseinrichtung |

| 609 | Strommesseinrichtung |
| --- | --- |
| 611 | Prozessoreinheit |
| 613 | Spannungsmesspunkt |
| 615 | Strommesspunkt |
| 617 | Steuerungseinheit |
| 619 | Kommunikationsverbindung |

| 700 | Ethernet-Netzwerkaufbau |
| --- | --- |
| 701 | Ethernet-Klemmensystem |
| 701 | Ethernet-Koppler |
| 703 | externer Datenbus |
| 705 | externe Schnittstelle |
| 707 | interne Schnittstelle |
| 709 | Spannungsmesseinrichtungsklemme |
| 711 | Strommesseinrichtungsklemme |
| 713 | interner Datenbus |
| RX | Empfangseinheit |
| TX | Sendeeinheit |
| ET | Telegramm |

| 900 | Datenabschnitt |
| --- | --- |
| 901 | Datenrahmen |
| 903 | erster Datenabschnitt |
| 905 | zweiter Datenabschnitt |
| 907 | dritter Datenabschnitt |
| 909 | vierter Datenabschnitt |
| 911 | fünfter Datenabschnitt |
| 913 | Kanalnummer |
| 915 | Zeitstempel |

| 1001 | Speichermedium |
| --- | --- |
| 1000 | Computerprogramm |

| P | Wirkleistung |
| --- | --- |
| Q | Blindleistung |
| D | Verzerrungsblindleistung |
| S | Gesamtscheinleistung |
| L | Leistungswert |

**Patentansprüche**

1. Verfahren (100) zur verteilten elektrischen Leistungsbestimmung zumindest eines Verbrauchers (605), der über einen Spannungspfad (603) mit einer Spannungsquelle (601) verbunden ist, wobei eine Spannungsmesseinrichtung (607) eine Versorgungsspannung (U) der Spannungsquelle (601) an einem Spannungsmesspunkt (613) auf dem Spannungspfad (603) bestimmt, und wobei zumindest eine Strommesseinrichtung (609) einen Verbraucherstrom (I) des Verbrauchers (605) an einem Strommesspunkt (615) auf dem Spannungspfad (603) bestimmt, die Verfahrensschritte umfassend:

   Aufnehmen von Spannungsesswerten (DPU) der Versorgungsspannung (U) durch die Spannungsmesseinrichtung (607) zur Bestimmung eines Spannungsverlaufs (TCU) der Versorgungsspannung (U) in einem Spannungsmessschritt (101);
   Aufnehmen von Strommesswerten (DPI) eines Verbraucherstroms (I) des zumindest einen Verbrauchers (605) durch die zumindest eine Strommesseinrichtung (609) zur Bestimmung eines Stromverlaufs (TCI) des Verbraucherstroms (I) in einem Strommessschritt (103);
   **gekennzeichnet durch**,
   Analysieren der Spannungsmesswerte (DPU) der Versorgungsspannung (U) und/oder der Stromesswerte (DPI) des Verbraucherstroms (I) mit einer Analysefunktion (AF) und Bestimmen von Spannungskenngrößen (AFPU) des Spannungsverlaufs (TCU) der Versorgungsspannung (U) und/oder von Stromkenngrößen (AFPI) des Stromverlaufs (TCI) des Verbraucherstroms (I) in einem Analyseschritt (105), wobei die Analyse der Spannungsmesswerte (DPU) der Versorgungsspannung (U) in dem Analyseschritt (105) von der Spannungsmesseinrichtung (607) durchgeführt wird, und/oder wobei die Analyse der Strommesswerte (DPI) des Verbraucherstroms (I) in dem Analyseschritt (105) von der zumindest einen Strommesseinrichtung (609) durchgeführt wird, wobei die Analysefunktion (AF) als eine mathematische Funktion ausgebildet ist, und wobei die Spannungskenngrößen (AFPU) und/oder die Stromkenngrößen (AFPI) Parameter der Analysefunktion (AF) sind;
Übermitteln der Spannungskenngrößen (AFPU) durch die Spannungsmesseinrichtung (607) an eine Prozessoreinheit (611) und/oder Übermitteln der Stromkenngrößen (AFPI) durch die zumindest eine Strommesseinrichtung (609) an die Prozessoreinheit (611); und
Ermitteln zumindest eines Leistungswerts (L) unter Berücksichtigung der Spannungskenngrößen (AFPU) des Spannungsverlaufs (TCU) der Versorgungsspannung (U) und/oder der Stromkenngrößen (AFPI) des Stromverlaufs (TCI) des Verbraucherstroms (I) durch die Prozessoreinheit (611) in einem Leistungswertermittlungsschritt (107).

2. Verfahren (100) nach Anspruch 1, wobei der Analyseschritt (105) der Spannungsmesswerte (DPU) und/oder der Stromesswerte (DPI) die Verfahrensschritte umfasst:

Durchführen einer Spektralanalyse, insbesondere einer diskreten Fourier-Analyse, der Spannungsmesswerte (DPU) und/oder der Strommesswerte (DPI) in einem Spektralanalyseschritt (201);
Erstellen eines Spannungsfrequenzspektrums (SDU) der Versorgungsspannung (U) auf Basis der Spektralanalyse der Spannungsmesswerte (DPU) und/oder eines Stromfrequenzspektrums (SDI) des Verbraucherstroms (I) auf Basis der Spektralanalyse der Strommesswerte (DPI) in einem Spektrumerstellungsschritt (203);
Reduzieren des Spannungsfrequenzspektrums (SDU) der Versorgungsspannung (U) und/oder des Stromfrequenzspektrums (SDI) des Verbraucherstroms (I) auf Frequenzen einer Spannungsgrundfrequenz (Uo) und von ersten n Spannungsoberfrequenzen $(U_1,...,U_n)$ der Versorgungsspannung (U) und/oder auf Frequenzen einer Stromgrundfrequenz $(I_0)$ und von ersten n Stromoberfrequenzen $(I_1,...,I_n)$ des Verbraucherstroms (I) in einem Reduktionsschritt (205); und
Identifizieren der Spannungsspektralwerte $(SDU_0,SDU_1,...,SDU_n)$ für Frequenzen der Spannungsgrundfrequenz (Uo) und der ersten n Spannungsoberfrequenzen $(U_1,...,U_n)$ der Versorgungsspannung (U) als Spannungskenngrößen (AFPU) und/oder der Stromspektralwerte $(SDI_0,SDI_1,...,SDI_n)$ für Frequenzen der Stromgrundfrequenz $(I_0)$ und der ersten n Stromoberfrequenzen $(I_1,...,I_n)$ des Verbraucherstroms (I) als Stromkenngrößen (AFPI) in einem Spektralwertidentifikationsschritt (207).

3. Verfahren (100) nach Anspruch 1, wobei der Analyseschritt (105) der Spannungsmesswerte (DPU) und/oder der Strommesswerte (DPI) die Verfahrensschritte umfasst:

Durchführen eines Anpassungsprozesses einer Anpassungsfunktion an die Spannungsmesswerte (DPU) und/oder die Strommesswerte (DPI) in einem Anpassungsschritt (501);
Ermitteln von Spannungsparametern (PU) der Anpassungsfunktion, wobei die Anpassungsfunktion mit den Spannungsparametern (PU) den Spannungsverlauf (TCU) der Versorgungsspannung (U) beschreibt, und/oder von Stromparametern (PI) der Anpassungsfunktion, wobei die Anpassungsfunktion mit den Stromparametern (PI) den Stromverlauf (TCI) des Verbraucherstroms (I) beschreibt, in einem Parameterermittlungsschritt (503); und
Identifizieren der Spannungsparameter (PU) der Anpassungsfunktion als Spannungskenngrößen (AFPU) und/oder der Stromparameter (PI) der Anpassungsfunktion als Stromkenngrößen (AFPI) in einem Parameteridentifikationsschritt (505).

4. Verfahren (100) nach einem der vorangehenden Ansprüche, ferner umfassend:
Synchronisieren der Spannungsmesseinrichtung (607) und der zumindest einen Strommesseinrichtung (609) auf eine Referenzzeit in einem Synchronisationsschritt (209), wobei die Spannungsmesseinrichtung (607) und die zumindest eine Strommesseinrichtung (609) jeweils eine lokale Zeit bestimmen, und wobei die lokale Zeit der Spannungsmesseinrichtung (607) und die lokale Zeit der zumindest einen Strommesseinrichtung (609) in Bezug auf die Referenzzeit angepasst werden.

5. Verfahren (100) nach Anspruch 4, wobei die Synchronisation der Spannungsmesseinrichtung (607) und der zumindest einen Strommesseinrichtung (609) in dem Synchronisationsschritt (209) das Ermitteln einer Phasenverschiebung ($\Delta\Phi$) zwischen dem Spannungsverlauf (TCU) der Versorgungsspannung (U) und dem Stromverlauf (TCI) des Verbraucherstroms (I) in einem Phasenverschiebungsermittlungsschritt (401) umfasst.

6. Verfahren (100) nach einem der vorangehenden Ansprüche, wobei der zumindest eine Leistungswert (L) eine Wirkleistung (P), eine Blindleistung (Q), eine Verzerrungsblindleistung (D) oder eine Gesamtscheinleistung (S) ist.

7. System (600) zur verteilten elektrischen Leistungsbestimmung mit einer Spannungsquelle (601) zum Bereitstellen einer Versorgungsspannung (U), zumindest einem Verbraucher (605), der über zumindest einen Spannungspfad (603) mit der Spannungsquelle (601) verbunden ist, einer Spannungsmesseinrichtung (607) zur Messung der Versorgungsspannung (U) an einem Spannungsmesspunkt (613) auf dem Spannungspfad (603), zumindest einer Strommesseinrichtungen (609) zur Messung eines Versorgungsstroms (I) des Verbrauchers (605) an einem Strommesspunkt (615) auf dem Spannungspfad (603), eine Prozessoreinheit (611) zum Erstellen zumindest eines Leistungswerts (L), und einer Steuerungseinheit (617) zum Ansteuern der Spannungsmesseinrichtung (607) und der zumindest einen Strommesseinrichtung (609), **dadurch gekennzeichnet, dass**

die Spannungsmesseinrichtung (607) ausgebildet ist, Spannungsmesswerte (DPU) der Versorgungsspannung (U) aufzunehmen, um einen Spannungsverlauf (TCU) der Versorgungsspannung (U) zu bestimmen, die Spannungsmesswerte (DPU) mit einer Analysefunktion (AF) zu analysieren und Spannungskenngrößen (AFPU) des Spannungsverlaufs (TCU) der Spannungsmesswerte (DPU) zu bestimmen, ein erstes Datenpaket (DP1) zu erstellen, das die Spannungskenngrößen (AFPU) umfasst, und das erste Datenpaket (DP1) an die zumindest eine Prozessoreinheit (611) zu übermitteln, wobei die Analysefunktion (AF) als eine mathematische Funktion ausgebildet ist, und wobei die Spannungskenngrößen (AFPU) Parameter der Analysefunktion (AF) sind;
wobei die zumindest eine Strommesseinrichtung (609) ausgebildet ist, Strommesswerte (DPI) der Verbraucherstroms (I) aufzunehmen, um einen Stromverlauf (TCI) des Verbraucherstroms (I) zu bestimmen, die Strommesswerte (DPI) mit der Analysefunktion (AF) zu analysieren und Stromkenngrößen (AFPI) des Stromverlaufs (TCI) der Strommesswerte (DPI) zu bestimmen, ein zweites Datenpaket (DP2) zu erstellen , das die Stromkenngrößen (AFPI) umfasst, und das zweite Datenpaket (DP2) an die zumindest eine Prozessoreinheit (611) zu übermitteln, wobei die Stromkenngrößen (AFPI) Parameter der Analysefunktion (AF) sind; und
wobei die zumindest eine Prozessoreinheit (611) ausgebildet ist, zumindest einen Leistungswert (L) unter Berücksichtigung der Spannungskenngrößen (AFPU) und/oder der Stromkenngrößen (AFPI) zu ermitteln.

8. System (600) nach Anspruch 7, wobei die Spannungsmesseinrichtung (607), die zumindest eine Strommesseinrichtung (609) und die Prozessoreinheit (611) ausgebildet sind, zum Analysieren der Spannungsmesswerte (DPU) und/oder der Strommesswerte (DPI) mit der Analysefunktion (AF) ausgebildet sind:

eine Spektralanalyse, insbesondere eine diskrete Fourier-Analyse, der Spannungsmesswerte (DPU) und/oder der Strommesswerte (DPI) durchzuführen;
ein Spannungsfrequenzspektrum (SDU) der Versorgungsspannung (U) auf Basis der Spektralanalyse der Spannungsmesswerte (DPU) und/oder ein Stromfrequenzspektrum (SDI) des Verbraucherstroms (I) auf Basis der Spektralanalyse der Strommesswerte (DPI) zu erstellen;
das Spannungsfrequenzspektrum (SDU) der Versorgungsspannung (U) und/oder das Stromfrequenzspektrum (SDI) des Verbraucherstroms (I) auf Spannungsspektralwerte ($SDU_0$, $SDU_1$, ..., $SDU_n$) einer Spannungsgrundfrequenz (Uo) und von ersten n Spannungsoberfrequenzen ($U_1$,...,$U_n$) der Versorgungsspannung (U) und/oder auf Stromspektralwerte ($SDI_0$,$SDI_1$,...,$SDI_n$) einer Stromgrundfrequenz ($I_0$) und von ersten n Stromoberfrequenzen ($I_1$,...,$I_n$) des Verbraucherstroms (I) zu reduzieren; und
die Spannungsspektralwerte ($SDU_0$,$SDU_1$,...,$SDU_n$) für Frequenzen der Spannungsgrundfrequenz (Uo) und der ersten n Spannungsoberfrequenzen ($U_1$,...,$U_n$) der Versorgungsspannung (U) als Spannungskenngrößen (AFPU) und/oder die Stromspektralwerte ($SDI_0$,$SDI_1$,...,$SDI_n$) für Frequenzen der Stromgrundfrequenz ($I_0$) und der ersten n Stromoberfrequenzen ($I_1$,...,$I_n$) des Verbraucherstroms (I) als Stromkenngrößen (AFPI) zu identifizieren.

9. System (600) nach Anspruch 7, wobei die Spannungsmesseinrichtung (607), die zumindest eine Strommesseinrichtung (609) und die Prozessoreinheit (611) ausgebildet sind, zum Analysieren der Spannungsmesswerte (DPU) und/oder der Strommesswerte (DPI) mit der Analysefunktion (AF) ausgebildet sind:

einen Anpassungsprozess einer Anpassungsfunktion an die Spannungsmesswerte (DPU) und/oder die Strommesswerte (DPI) durchzuführen;
Spannungsparameter (PU) und/oder Stromparameter (PI) der Anpassungsfunktion zu bestimmen; und
die Spannungsparameter (PU) der Anpassungsfunktion als Spannungskenngrößen (AFPU) und/oder die Stromparameter (PI) der Anpassungsfunktion als Stromkenngrößen (AFPI) zu identifizieren.

**10.** System (600) nach einem der vorangehenden Ansprüche 7 bis 9, ferner umfassend zumindest eine Kommunikationsverbindung (619) zwischen der Spannungsmesseinrichtung (607) und der zumindest einen Prozessoreinheit (611) und/oder der zumindest einen Strommesseinrichtung (609) und der zumindest einen Prozessoreinheit (611) zum Übermitteln des ersten Datenpakets (DP1) von der Spannungsmesseinrichtung (607) an die zumindest eine Prozessoreinheit (611) und/oder des zweiten Datenpakets (DP2) von der zumindest einen Strommesseinrichtung (609) an die zumindest eine Prozessoreinheit (611).

**11.** System (600) nach einem der voranstehenden Ansprüche 7 bis 10, wobei die zumindest eine Prozessoreinheit (611) in der Spannungsmesseinrichtung (607) und/oder in der zumindest einen Strommesseinrichtung (609) ausgebildet ist oder eine externe Prozessoreinheit (611) ist.

**12.** System (600) nach einem der voranstehenden Ansprüche 7 bis 11, wobei die Spannungsmesseinrichtung (607) und die zumindest eine Strommesseinrichtung (609) zueinander synchronisierbar sind, wobei die Spannungsmesseinrichtung (607) und die zumindest eine Strommesseinrichtung (609) hierzu jeweils eine lokale Zeit aufweisen, und wobei die lokalen Zeiten der Spannungsmesseinrichtung (607) und der zumindest einen Strommesseinrichtung (609) auf eine globale Referenzzeit des Systems (600) abstimmbar sind.

## Claims

**1.** Method (100) for distributed electrical power determination for at least one load (605) that is connected to a voltage source (601) via a voltage path (603), wherein a voltage measuring device (607) determines a supply voltage (U) of the voltage source (601) at a voltage measuring point (613) on the voltage path (603), and wherein at least one current measuring device (609) determines a load current (I) of the load (605) at a current measuring point (615) on the voltage path (603), comprising the method steps:

recording voltage measured values (DPU) of the supply voltage (U) by way of the voltage measuring device (607) to determine a voltage profile (TCU) of the supply voltage (U) in a voltage measuring step (101);
recording current measured values (DPI) of a load current (I) of the at least one load (605) by way of the at least one current measuring device (609) to determine a current profile (TCI) of the load current (I) in a current measuring step (103);
**characterized by**
analysing the voltage measured values (DPU) of the supply voltage (U) and/or the current measured values (DPI) of the load current (I) with an analysis function (AF) and determining voltage characteristic variables (AFPU) of the voltage profile (TCU) of the supply voltage (U) and/or current characteristic variables (AFPI) of the current profile (TCI) of the load current (I) in an analysis step (105), wherein the analysis of the voltage measured values (DPU) of the supply voltage (U) in the analysis step (105) is carried out by the voltage measuring device (607), and/or wherein the analysis of the current measured values (DPI) of the load current (I) in the analysis step (105) is carried out by the at least one current measuring device (609), wherein the analysis function (AF) is in the form of a mathematical function, and wherein the voltage characteristic variables (AFPU) and/or the current characteristic variables (AFPI) are parameters of the analysis function (AF);
transmitting the voltage characteristic variables (AFPU) to a processor unit (611) by way of the voltage measuring device (607) and/or transmitting the current characteristic variables (AFPI) to the processor unit (611) by way of the at least one current measuring device (609); and
ascertaining at least one power value (L), taking into consideration the voltage characteristic variables (AFPU) of the voltage profile (TCU) of the supply voltage (U) and/or the current characteristic variables (AFPI) of the current profile (TCI) of the load current (I), by way of the processor unit (611) in a power value ascertainment step (107).

**2.** Method (100) according to Claim 1, wherein the step (105) of analysing the voltage measured values (DPU) and/or the current measured values (DPI) comprises the method steps:

carrying out spectral analysis, in particular discrete Fourier analysis, of the voltage measured values (DPU) and/or the current measured values (DPI) in a spectral analysis step (201);
creating a voltage frequency spectrum (SDU) of the supply voltage (U) on the basis of the spectral analysis of the voltage measured values (DPU) and/or a current frequency spectrum (SDI) of the load current (I) on the basis of the spectral analysis of the current measured values (DPI) in a spectrum creation step (203);

reducing the voltage frequency spectrum (SDU) of the supply voltage (U) and/or the current frequency spectrum (SDI) of the load current (I) to frequencies of a voltage fundamental frequency (Uo) and of first n voltage harmonic frequencies ($U_1,...,U_n$) of the supply voltage (U) and/or to frequencies of a current fundamental frequency ($I_0$) and of first n current harmonic frequencies ($I_1,...,I_n$) of the load current (I) in a reduction step (205); and

identifying the voltage spectral values ($SDU_0, SDU_1,..., SDU_n$) for frequencies of the voltage fundamental frequency (Uo) and the first n voltage harmonic frequencies ($U_1,...,U_n$) of the supply voltage (U) as voltage characteristic variables (AFPU) and/or the current spectral values ($SDI_0, SDI_1,..., SDI_n$) for frequencies of the current fundamental frequency ($I_0$) and the first n current harmonic frequencies ($I_1,...,I_n$) of the load current (I) as current characteristic variables (AFPI) in a spectral value identification step (207).

3. Method (100) according to Claim 1, wherein the step (105) of analysing the voltage measured values (DPU) and/or the current measured values (DPI) comprises the method steps:

carrying out a process of adapting an adaptation function to the voltage measured values (DPU) and/or the current measured values (DPI) in an adaptation step (501);

ascertaining voltage parameters (PU) of the adaptation function, wherein the adaptation function uses the voltage parameters (PU) to describe the voltage profile (TCU) of the supply voltage (U) and/or current parameters (PI) of the adaptation function, wherein the adaptation function uses the current parameters (PI) to describe the current profile (TCI) of the load current (I), in a parameter ascertainment step (503); and

identifying the voltage parameters (PU) of the adaptation function as voltage characteristic variables (AFPU) and/or the current parameters (PI) of the adaptation function as current characteristic variables (AFPI) in a parameter identification step (505).

4. Method (100) according to one of the preceding claims, also comprising:
synchronizing the voltage measuring device (607) and the at least one current measuring device (609) to a reference time in a synchronization step (209), wherein the voltage measuring device (607) and the at least one current measuring device (609) each determine a local time, and wherein the local time of the voltage measuring device (607) and the local time of the at least one current measuring device (609) are adapted in respect of the reference time.

5. Method (100) according to Claim 4, wherein the synchronization of the voltage measuring device (607) and the at least one current measuring device (609) in the synchronization step (209) comprises ascertaining a phase shift ($\Delta\phi$) between the voltage profile (TCU) of the supply voltage (U) and the current profile (TCI) of the load current (I) in a phase shift ascertainment step (401) .

6. Method (100) according to one of the preceding claims, wherein the at least one power value (L) is an active power (P), a reactive power (Q), a distortion reactive power (D) or an overall apparent power (S).

7. System (600) for distributed electrical power determination, having a voltage source (601) for providing a supply voltage (U), at least one load (605) that is connected to the voltage source (601) via at least one voltage path (603), a voltage measuring device (607) for measuring the supply voltage (U) at a voltage measuring point (613) on the voltage path (603), at least one current measuring device (609) for measuring a supply current (I) of the load (605) at a current measuring point (615) on the voltage path (603), a processor unit (611) for creating at least one power value (L), and a control unit (617) for actuating the voltage measuring device (607) and the at least one current measuring device (609),
**characterized in that**

the voltage measuring device (607) is designed to record voltage measured values (DPU) of the supply voltage (U) in order to determine a voltage profile (TCU) of the supply voltage (U), to analyse the voltage measured values (DPU) with an analysis function (AF) and to determine voltage characteristic variables (AFPU) of the voltage profile (TCU) of the voltage measured values (DPU), to create a first data packet (DP1) that comprises the voltage characteristic variables (AFPU) and to transmit the first data packet (DP1) to the at least one processor unit (611), wherein the analysis function (AF) is in the form of a mathematical function, and wherein the voltage characteristic variables (AFPU) are parameters of the analysis function (AF);

wherein the at least one current measuring device (609) is designed to record current measured values (DPI) of the load current (I) in order to determine a current profile (TCI) of the load current (I), to analyse the current measured values (DPI) with the analysis function (AF) and to determine current characteristic variables (AFPI) of the current profile (TCI) of the current measured values (DPI), to create a second data packet (DP2) that comprises the current characteristic variables (AFPI) and to transmit the second data packet (DP2) to the at least one processor unit (611), wherein the current characteristic variables (AFPI) are parameters of the analysis function (AF); and

wherein the at least one processor unit (611) is designed to ascertain at least one power value (L), taking into consideration the voltage characteristic variables (AFPU) and/or the current characteristic variables (AFPI).

8. System (600) according to Claim 7, wherein the voltage measuring device (607), the at least one current measuring device (609) and the processor unit (611) are designed to analyse the voltage measured values (DPU) and/or the current measured values (DPI) with the analysis function (AF) are designed:

to carry out spectral analysis, in particular discrete Fourier analysis, of the voltage measured values (DPU) and/or the current measured values (DPI);
to create a voltage frequency spectrum (SDU) of the supply voltage (U) on the basis of the spectral analysis of the voltage measured values (DPU) and/or a current frequency spectrum (SDI) of the load current (I) on the basis of the spectral analysis of the current measured values (DPI);
to reduce the voltage frequency spectrum (SDU) of the supply voltage (U) and/or the current frequency spectrum (SDI) of the load current (I) to voltage spectral values ($SDU_0$, $SDU_1$,..., $SDU_n$) of a voltage fundamental frequency (Uo) and of first n voltage harmonic frequencies ($U_1$,...,$U_n$) of the supply voltage (U) and/or to current spectral values ($SDI_0$, $SDI_1$,..., $SDI_n$) of a current fundamental frequency ($I_0$) and of first n current harmonic frequencies ($I_1$,...,$I_n$) of the load current (I); and
to identify the voltage spectral values ($SDU_0$, $SDU_1$,..., $SDU_n$) for frequencies of the voltage fundamental frequency (Uo) and the first n voltage harmonic frequencies ($U_1$,...,$U_n$) of the supply voltage (U) as voltage characteristic variables (AFPU) and/or the current spectral values ($SDI_0$, $SDI_1$,..., $SDI_n$) for frequencies of the current fundamental frequency ($I_0$) and the first n current harmonic frequencies ($I_1$,...,$I_n$) of the load current (I) as current characteristic variables (AFPI).

9. System (600) according to Claim 7, wherein the voltage measuring device (607), the at least one current measuring device (609) and the processor unit (611) are designed to analyse the voltage measured values (DPU) and/or the current measured values (DPI) with the analysis function (AF) are designed:

to carry out a process of adapting an adaptation function to the voltage measured values (DPU) and/or the current measured values (DPI);
to determine voltage parameters (PU) and/or current parameters (PI) of the adaptation function; and
to identify the voltage parameters (PU) of the adaptation function as voltage characteristic variables (AFPU) and/or the current parameters (PI) of the adaptation function as current characteristic variables (AFPI).

10. System (600) according to one of the preceding Claims 7 to 9, also comprising at least one communication connection (619) between the voltage measuring device (607) and the at least one processor unit (611) and/or the at least one current measuring device (609) and the at least one processor unit (611) for transmitting the first data packet (DP1) from the voltage measuring device (607) to the at least one processor unit (611) and/or the second data packet (DP2) from the at least one current measuring device (609) to the at least one processor unit (611) .

11. System (600) according to one of the preceding Claims 7 to 10, wherein the at least one processor unit (611) is formed in the voltage measuring device (607) and/or in the at least one current measuring device (609) or is an external processor unit (611).

12. System (600) according to one of the preceding Claims 7 to 11, wherein the voltage measuring device (607) and the at least one current measuring device (609) can be synchronized with one another, wherein the voltage measuring device (607) and the at least one current measuring device (609) each have a local time for this purpose, and wherein the local times of the voltage measuring device (607) and the at least one current measuring device (609) can be adjusted to a global reference time of the system (600).

**Revendications**

1. Procédé (100) de détermination de la puissance électrique distribuée d'au moins un consommateur (605) qui est relié à une source de tension (601) par le biais d'un chemin de tension (603), un dispositif de mesure de tension (607) déterminant une tension d'alimentation (U) de la source de tension (601) à un point de mesure de tension (613) sur le chemin de tension (603), et au moins un dispositif de mesure de courant (609) déterminant un courant de consommateur (I) du consommateur (605) à un point de mesure de courant (615) sur le chemin de tension (603), ledit procédé comprenant les étapes suivantes :

acquérir des valeurs de mesure de tension (DPU) de la tension d'alimentation (U) par le biais du dispositif de mesure de tension (607) pour déterminer un profil de tension (TCU) de la tension d'alimentation (U) dans une étape de mesure de tension (101) ;

acquérir des valeurs de mesure de courant (DPI) d'un courant de consommateur (I) de l'au moins un consommateur (605) par le biais de l'au moins un dispositif de mesure de courant (609) pour déterminer un profil de courant (TCI) du courant de consommateur (I) dans une étape de mesure de courant (103) ;

**caractérisé par** les étapes suivantes

analyser des valeurs de mesure de tension (DPU) de la tension d'alimentation (U) et/ou des valeurs de mesure de courant (DPI) du courant de consommateur (I) avec une fonction d'analyse (AF) et déterminer des paramètres de tension (AFPU) du profil de tension (TCU) de la tension d'alimentation (U) et/ou des paramètres de courant (AFPI) du profil de courant (TCI) du courant de consommateur (I) dans une étape d'analyse (105), l'analyse des valeurs de mesure de tension (DPU) de la tension d'alimentation (U) à l'étape d'analyse (105) étant effectuée par le dispositif de mesure de tension (607), et/ou l'analyse des valeurs de mesure de courant (DPI) du courant de consommateur (I) à l'étape d'analyse (105) étant effectuée par l'au moins un dispositif de mesure de courant (609), la fonction d'analyse (AF) étant conçue comme une fonction mathématique, et les paramètres de tension (AFPU) et/ou les paramètres de courant (AFPI) étant des paramètres de la fonction d'analyse (AF) ;

transmettre des paramètres de tension (AFPU) par le biais du dispositif de mesure de tension (607) à une unité de traitement (611) et/ou transmettre des paramètres de courant (AFPI) par le biais de l'au moins un dispositif de mesure de courant (609) à l'unité de traitement (611) ; et

déterminer au moins une valeur de puissance (L) avec prise en compte des paramètres de tension (AFPU) du profil de tension (TCU) de la tension d'alimentation (U) et/ou des paramètres de courant (AFPI) du profil de courant (TCI) du courant de consommateur (I) par le biais de l'unité de processeur (611) dans une étape de détermination de valeur de puissance (107).

2. Procédé (100) selon la revendication 1, l'étape d'analyse (105) des valeurs de mesure de tension (DPU) et/ou des valeurs de mesure de courant (DPI) comprenant les étapes de procédé suivantes :

effectuer une analyse spectrale, notamment une analyse de Fourier discrète, des valeurs de mesure de tension (DPU) et/ou des valeurs de mesure de courant (DPI) dans une étape d'analyse spectrale (201) ;

établir un spectre tension-fréquence (SDU) de la tension d'alimentation (U) sur la base de l'analyse spectrale des valeurs de mesure de tension (DPU) et/ou un spectre courant-fréquence (SDI) du courant de consommateur (I) sur la base de l'analyse spectrale des valeurs de mesure de courant (DPI) dans une étape d'établissement de spectre (203) ;

réduire le spectre de fréquence de tension (SDU) de la tension d'alimentation (U) et/ou le spectre de fréquence de courant (SDI) du courant de consommateur (I) à des fréquences d'une fréquence de tension fondamentale (Uo) et de n premières fréquences de tension harmoniques ($U_1$,..., $U_n$) de la tension d'alimentation (U) et/ou à des fréquences d'une fréquence de courant fondamentale ($I_0$) et de n premières fréquences de courant harmoniques ($I_1$,...,$I_n$) du courant de consommateur (I) dans une étape de réduction (205) ; et

identifier des valeurs de tension spectrales ($SDU_0$, $SDU_1$,..., $SDU_n$) pour des fréquences de la fréquence de tension fondamentale (Uo) et de n premières fréquences de tension harmoniques ($U_1$,...,$U_n$) de la tension d'alimentation (U) comme paramètres de tension (AFPU) et/ou des valeurs de courant spectrales ($SDI_0$, $SDI_1$,..., $SDI_n$) pour des fréquences de la fréquence de courant fondamentale ($I_0$) et de n premières fréquences de courant harmoniques ($I_1$,..., $I_n$) du courant de consommateur (I) comme paramètres de courant (AFPI) dans une étape d'identification de valeur spectrale (207) .

3. Procédé (100) selon la revendication 1, l'étape d'analyse (105) des valeurs de mesure de tension (DPU) et/ou des valeurs de mesure de courant (DPI) comprenant les étapes de procédé suivantes :

effectuer un processus d'adaptation d'une fonction d'adaptation aux valeurs de mesure de tension (DPU) et/ou aux valeurs de mesure de courant (DPI) dans une étape d'adaptation (501) ;

déterminer des paramètres de tension (PU) de la fonction d'adaptation, la fonction d'adaptation avec les paramètres de tension (PU) décrivant le profil de tension (TCU) de la tension d'alimentation (U), et/ou des paramètres de courant (PI) de la fonction d'adaptation, la fonction d'adaptation avec les paramètres de courant (PI) décrivant le profil de courant (TCI) du courant de consommateur (I), dans une étape de détermination de paramètre (503) ; et

identifier les paramètres de tension (PU) de la fonction d'adaptation comme paramètres de tension (AFPU) et/ou les paramètres de courant (PI) de la fonction d'adaptation comme paramètres de courant (AFPI) dans une étape d'identification de paramètre (505) .

4.  Procédé (100) selon l'une des revendications précédentes, comprenant en outre les étapes suivantes : synchroniser le dispositif de mesure de tension (607) et l'au moins un dispositif de mesure de courant (609) sur un temps de référence dans une étape de synchronisation (209), le dispositif de mesure de tension (607) et l'au moins un dispositif de mesure de courant (609) déterminant chacun un temps local, et le temps local du dispositif de mesure de tension (607) et le temps local de l'au moins un dispositif de mesure de courant (609) étant adaptés par rapport au temps de référence.

5.  Procédé (100) selon la revendication 4, la synchronisation du dispositif de mesure de tension (607) et de l'au moins un dispositif de mesure de courant (609) à l'étape de synchronisation (209) comprenant la détermination d'un déphasage ($\Delta\Phi$) entre le profil de tension (TCU) de la tension d'alimentation (U) et le profil de courant (TCI) du courant de consommateur (I) à une étape de détection de déphasage (401) .

6.  Procédé (100) selon l'une des revendications précédentes, l'au moins une valeur de puissance (L) étant une puissance active (P), une puissance réactive (Q), une puissance réactive de distorsion (D) ou une puissance apparente totale (S).

7.  Système (600) de détermination de puissance électrique distribuée comprenant une source de tension (601) destinée à fournir une tension d'alimentation (U), au moins un consommateur (605) qui est connecté à la source de tension (601) par le biais de l'au moins un chemin de tension (603), un dispositif de mesure de tension (607) destiné à mesurer la tension d'alimentation (U) à un point de mesure de tension (613) sur le chemin de tension (603), au moins un dispositif de mesure de courant (609) destiné à mesurer un courant d'alimentation (I) du consommateur (605) à un point de mesure de courant (615) sur le chemin de tension (603), une unité de traitement (611) destinée à établir au moins une valeur de puissance (L) et une unité de commande (617) destinée à commander le dispositif de mesure de tension (607) et l'au moins un dispositif de mesure de courant (609),

    **caractérisé en ce que**

    le dispositif de mesure de tension (607) est conçu pour acquérir des valeurs de mesure de tension (DPU) de la tension d'alimentation (U) afin de déterminer un profil de tension (TCU) de la tension d'alimentation (U), analyser les valeurs de mesure de tension (DPU) avec une fonction d'analyse (AF) et déterminer des paramètres de tension (AFPU) du profil de tension (TCU) des valeurs de mesure de tension (DPU), créer un premier paquet de données (DP1) qui comprend les paramètres de tension (AFPU), et transmettre le premier paquet de données (DP1) à l'au moins une unité de traitement (611), la fonction d'analyse (AF) étant conçue comme une fonction mathématique, et les paramètres de tension (AFPU) étant des paramètres de la fonction d'analyse (AF) ;

    l'au moins un dispositif de mesure de courant (609) étant conçu pour acquérir des valeurs de mesure de courant (DPI) du courant de consommateur (I) afin de déterminer un profil de courant (TCI) du courant de consommateur (I), analyser les valeurs de mesure de courant (DPI) avec la fonction d'analyse (AF) et déterminer des paramètres de courant (AFPI) du profil de courant (TCI) des valeurs de mesure de courant (DPI), créer un deuxième paquet de données (DP2) qui comprend les paramètres de courant (AFPI), et transmettre le deuxième paquet de données (DP2) à l'au moins une unité de traitement (611), les paramètres de courant (AFPI) étant des paramètres de la fonction d'analyse (AF) ; et

    l'au moins une unité de traitement (611) étant conçue pour déterminer au moins une valeur de puissance (L) avec prise en compte des paramètres de tension (AFPU) et/ou des paramètres de courant (AFPI).

8.  Système (600) selon la revendication 7, le dispositif de mesure de tension (607), l'au moins un dispositif de mesure de courant (609) et l'unité de traitement (611) étant conçus pour analyser les valeurs de mesure de tension (DPU) et/ou les valeurs de mesure de courant (DPI) avec la fonction d'analyse (AF) étant conçus :

    effectuer une analyse spectrale, notamment une analyse de Fourier discrète, des valeurs de mesure de tension (DPU) et/ou des valeurs de mesure de courant (DPI) ;

    établir un spectre de fréquence de tension (SDU) de la tension d'alimentation (U) sur la base de l'analyse spectrale des valeurs de mesure de tension (DPU) et/ou un spectre de fréquence de courant (SDI) du courant de consommation (I) sur la base de l'analyse spectrale des valeurs de mesure de courant (DPI) ;

    réduire le spectre de fréquence de tension (SDU) de la tension d'alimentation (U) et/ou le spectre de fréquence de courant (SDI) du courant de consommation (I) à des valeurs de tension spectrales ($SDU_0$, $SDU_1$,..., $SDU_n$) d'une fréquence de tension fondamentale (Uo) et de n premières fréquences de tension harmoniques ($U_1$,...,$U_n$) de la tension d'alimentation (U) et/ou à des valeurs de courant spectrales ($SDI_0$, $SDI_1$,..., $SDI_n$) d'une fréquence de courant fondamentale ($I_0$) et de n premières fréquences de courant harmoniques ($I_1$,..., $I_n$) du courant de consommateur (I) ; et

identifier les valeurs de tension spectrales ($SDU_0$, $SDU_1$,..., $SDU_n$) pour les fréquences de la fréquence de tension fondamentale ($U_0$) et des n premières fréquences de tension harmoniques ($U_1$,...,$U_n$) de la tension d'alimentation (U) comme paramètres de tension (AFPU) et/ou les valeurs de courant spectrales ($SDI_0$, $SDI_1$,..., $SDI_n$) pour des fréquences de la fréquence de courant fondamentale ($I_0$) et les n premières fréquences de courant harmoniques ($I_1$,..., $I_n$) du courant de consommateur (I) comme paramètres de courant (AFPI).

9. Système (600) selon la revendication 7, le dispositif de mesure de tension (607), l'au moins un dispositif de mesure de courant (609) et l'unité de traitement (611) étant conçus pour analyser les valeurs de mesure de tension (DPU) et/ou les valeurs de mesure de courant (DPI) avec la fonction d'analyse (AF) étant conçus :

effectuer un processus d'adaptation d'une fonction d'adaptation aux valeurs de mesure de tension (DPU) et/ou aux valeurs de mesure de courant (DPI) ;
déterminer des paramètres de tension (PU) et/ou des paramètres de courant (PI) de la fonction d'adaptation ; et
identifier les paramètres de tension (PU) de la fonction d'adaptation comme paramètres de tension (AFPU) et/ou les paramètres de courant (PI) de la fonction d'adaptation comme paramètres de courant (AFPI).

10. Système (600) selon l'une des revendications précédentes 7 à 9, comprenant en outre au moins une liaison de communication (619) entre le dispositif de mesure de tension (607) et l'au moins une unité de traitement (611) et/ou l'au moins un dispositif de mesure de courant (609) et l'au moins une unité de traitement (611) pour transmettre le premier paquet de données (DP1) du dispositif de mesure de tension (607) à l'au moins une unité de traitement (611) et/ou le deuxième paquet de données (DP2) de l'au moins un dispositif de mesure de courant (609) à l'au moins une unité de traitement (611).

11. Système (600) selon l'une des revendications précédentes 7 à 10, l'au moins une unité de traitement (611) étant conçue dans le dispositif de mesure de tension (607) et/ou dans l'au moins un dispositif de mesure de courant (609) ou étant une unité de traitement extérieure (611).

12. Système (600) selon l'une des revendications précédentes 7 à 11, le dispositif de mesure de tension (607) et l'au moins un dispositif de mesure de courant (609) pouvant être synchronisés l'un avec l'autre, le dispositif de mesure de tension (607) et l'au moins un dispositif de mesure de courant (609) comportant chacun pour cela un temps local, et les temps locaux du dispositif de mesure de tension (607) et de l'au moins un dispositif de mesure de courant (609) pouvant être accordés sur un temps de référence global du système (600) .

EP 3 906 416 B1

**Fig. 1**

100

```
┌──────────┐        ┌──────────┐
│   101    │        │   103    │
└────┬─────┘        └────┬─────┘
     │                   │
     ▼                   ▼
┌────────────────────────────────┐
│             105                │
└────────────────┬───────────────┘
                 │
                 ▼
┌────────────────────────────────┐
│             107                │
└────────────────────────────────┘
```

Fig. 2

**Fig. 3**

**Fig. 4**

EP 3 906 416 B1

U

TCU

DPU

$t_U$

$T_1$

t

I

TCl

$t_I$

$\Delta\phi$

$T_2$

t

**Fig. 5**

Fig. 6

Fig. 7

**Fig. 8**

EP 3 906 416 B1

EP 3 906 416 B1

**Fig. 9**

DP1

901

| 913, 915 | $U_0$ | $SDU_{n+1}$ | $SDU_0$ | $SDU_1$ | $\phi_{U1}$ | | $SDU_n$ | $\phi_{Un}$ |

900, 903   900, 905   900, 907   900, 909   900, 911   900, 912   900   900

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2013009942 A1
- WO 2009140777 A1